# EUROPEAN PATENT APPLICATION

(11) **EP 2 346 123 A2**
(43) Date of publication of application: **20.07.2011**
(21) Application number: 11250017.8
(22) Date of filing: 10.01.2011
(51) Int. Cl.: H01S 5/183, H01S 5/42, H01S 5/343, B41J 2/435

(54) **Surface emitting laser element, surface emitting laser array, optical scanning apparatus, and image forming apparatus**

(30) Priority: 15.01.2010 JP 2010006457; 27.07.2010 JP 2010167704
(71) Applicant: Ricoh Company Ltd., Tokyo 143-8555 (JP)
(72) Inventor: Morimasa, Kaminishi, Tokyo 143-8555 (JP); Shunichi, Sato, Tokyo 143-8555 (JP)
(74) Representative: Leeming, John Gerard

(57) **Abstract**

A surface emitting laser element includes a p-side spacer layer (106); an n-side spacer layer (104); and an active layer (105) disposed between the p-side spacer layer (106) and the n-side spacer layer (104). The p-side spacer layer (106) includes an undoped region adjacent to the active layer (105) in which no p-type dopant is contained. The entire n-side spacer layer (104) is doped with an n-type dopant.

## Description

### BACKGROUND OF THE INVENTION

### 1. Field of the Invention

The present invention relates to a surface emitting laser element configured to emit light in a direction perpendicular to a substrate, and its application to a surface emitting laser array, an optical scanning apparatus, and an image forming apparatus.

### 2. Description of the Related Art

Vertical cavity surface emitting laser (VCSEL) elements are being increasingly used as a light source for various technologies, such as local area networks (LAN), optical interconnections, or in image forming apparatuses such as printers and copy machines. The VCSEL elements are advantageous in that they do not require cleaving during the manufacturing process, and that the elements can be tested in wafer form, so that the VCSEL elements can be manufactured at lower cost than the conventional edge-emitting semiconductor laser. The VCSEL elements have lower power consumption than the edge-emitting semiconductor laser. A VCSEL element is typically manufactured by stacking a number of semiconductor layers on a semiconductor substrate by epitaxial growth processes.

When a VCSEL element is used as a light source for optical communications or optical interconnections, high-speed modulation is required. When used as a light source for a write operation, quick response in terms of the rise and fall of optical output is required. Further, from the viewpoint of reliability, a lower current operation is desirable. Typically, a current is injected into the VCSEL element through a multilayer reflector for oscillation. The multilayer reflector includes a number of semiconductor layers with two different refractive indexes which are alternately stacked.

Because such a structure has a number of heterointerfaces, the multilayer reflector tends to have a large resistance. As a result, it is difficult to perform high-speed modulation due to the limitation on a modulation band imposed by the CR time constant. Also, the problem of heat generation due to current injection tends to occur. If the doping concentration of the multilayer reflector is increased in order to reduce the element resistance, oscillation is obstructed by light absorption. For achieving an increase in modulation speed, the element capacity of the VCSEL may be reduced by reducing the element size of the VCSEL. However, decrease in element size leads to a disadvantage in terms of dissipation of heat due to current injection.

In the VCSEL, a resonator having an active region and spacer layers is disposed between reflectors. The resonator has an optical length corresponding to an integer multiple of the resonant wavelength λ. At the time of oscillation, a region including the resonator is exposed to a strong electric field. Thus, when the resonator is doped, normally an area of several dozen nanometers or more adjacent the active region is maintained in an un-doped state, and a doped region is provided away from the non-doped region. This is in order to minimize light absorption and the influence of nonradiative recombination due to decrease in crystal quality.

Patent Document 1 discloses a laser comprising a p-spacer, an n-spacer, and an active region. The p-spacer has a p-doped region and an undoped region, and the n-spacer has an n-doped region and an undoped region. The active region is located between the undoped region of the p-spacer and the undoped region of the n-spacer. The active region emits light of the wavelength λ through recombination of holes and electrons. The undoped region of the p-spacer has a thickness different from that of the undoped region of the n-spacer. In this laser, a cavity structure has an optical length of (n+1)λ/2 (n is an integer of 2 or more) with respect to the oscillation wavelength λ, and the p-side non-doped area can be extended. In this case, however, the length of the cavity structure becomes longer than the optical length λ, which is often used as the length of the cavity structure. As a result, the element resistance may increase.

Patent Document 2 discloses an oxidized confinement type surface emitting semiconductor laser element. The laser element includes a substrate, a pair of p- and n-doped semiconductor multilayer reflectors, and an active layer disposed between the semiconductor multilayer reflectors via a pair of cladding layers. At least one of the cladding layers is doped with a first impurity of the same conductivity type as the conductivity type of the semiconductor multilayer reflector closer to the doped cladding layer. The doping concentration of the first impurity is set to be more than a concentration of an impurity of the same conductivity type as that of the first impurity that exists in the semiconductor multilayer reflector farther from the doped one cladding layer, and lower than a concentration of an impurity of the same conductivity type as that of the first impurity that exists in the semiconductor multilayer reflector closer to the doped cladding layer.

In the semiconductor laser element according to Patent Document 2, both the p- and n-spacer layers are doped in the regions adjacent the active layer so that the p-n junction can be located in the active layer. In this case, because there is a strong electric field in the resonator, free carrier absorption increases, particularly in the p-type spacer layer, resulting in an increase in the oscillation current threshold or a decrease in slope efficiency.
Patent Document 1: JP2004-327992
Patent Document 2: JP2003-115635

### SUMMARY OF THE INVENTION

It is therefore a general object of the present invention to overcome the aforementioned disadvantages of the related art.

A more specific object of the invention is to provide a surface-emitting laser element whose element resistance is reduced without degrading its light emitting characteristics.

Another object of the invention is to provide a surface-emitting laser array, an optical scanning apparatus, and an image forming apparatus using the surface-emitting laser element.

The disadvantages of the related art may be overcome by an aspect of the present invention which provides a surface emitting laser element that includes a p-side spacer layer; an n-side spacer layer; and an active layer disposed between the p-side spacer layer and the n-side spacer layer. The p-side spacer layer includes an undoped region adjacent the active layer in which no p-type dopant is contained. The entire n-side spacer layer is doped with an n-type dopant.

In another aspect, the invention provides a surface emitting laser array that includes plural of the surface emitting laser elements.

In another aspect, the invention provides an optical scanning apparatus that includes a light source including the surface emitting laser element; a deflector configured to deflect light emitted from the light source; and a scanning optical system configured to focus the light deflected by the deflector on a scanned surface.

In another aspect, the invention provides an optical scanning apparatus that includes a light source including the surface emitting laser array; a deflector configured to deflect light emitted from the light source; and a scanning optical system configured to focus the light deflected by the deflector on a scanned surface.

In another aspect, the invention provides an image forming apparatus that includes an image carrier; and the optical scanning apparatus configured to scan the image carrier with the light modulated in accordance with image information.

### BRIEF DESCRIPTION OF THE DRAWINGS

A complete understanding of the present invention may be obtained by reference to the accompanying drawings, when considered in conjunction with the subsequent, detailed description, in which:
FIG. 1 illustrates a laser printer according to an embodiment of the present invention;
FIG. 2 illustrates an optical scanning apparatus in the laser printer of FIG. 1;
FIG. 3 illustrates a surface emitting laser element according to Example 1 in a light source of the optical scanning apparatus of FIG. 2;
FIG. 4 illustrates an upper semiconductor DBR of the surface emitting laser element;
FIG. 5 illustrates a low-doping concentration area of the surface emitting laser element;
FIG. 6 illustrates a doping profile for the surface emitting laser element;
FIG. 7 illustrates another doping profile for the surface emitting laser element;
FIG. 8 illustrates a step of a process of manufacturing the surface emitting laser element;
FIG. 9 illustrates another step of the process of manufacturing the surface emitting laser element;
FIG. 10 illustrates another step of the process of manufacturing the surface emitting laser element;
FIG. 11 illustrates another step of the process of manufacturing the surface emitting laser element;
FIG. 12 illustrates another step of the process of manufacturing the surface emitting laser element;
FIG. 13 illustrates another step of the process of manufacturing the surface emitting laser element;
FIG. 14 illustrates another step of the process of manufacturing the surface emitting laser element;
FIG. 15 illustrates a doping profile for a surface emitting laser element according Example 2;
FIG. 16 illustrates another doping profile for the surface emitting laser element of Example 2;
FIG. 17 illustrates a surface emitting laser element according to Example 3;
FIG. 18 illustrates a variation of the surface emitting laser element of Example 3;
FIG. 19A illustrates a doping concentration at and near an interface between the lower semiconductor DBR and the lower spacer layer according to an embodiment of the present invention;
FIG. 19B illustrates a doping concentration at and near an interface between the lower semiconductor DBR and the lower spacer layer according to the related art;
FIG. 20 illustrates a surface emitting laser array according to an embodiment of the present invention;
FIG. 21 is a cross section taken along line A-A' of FIG. 20;
FIG. 22 illustrates a surface emitting laser element according to Example 4;
FIG. 23 illustrates a surface emitting laser element according to Example 5;
FIG. 24 illustrates a cavity structure of the surface emitting laser element according to Example 5;
FIG. 25 illustrates a doping profile for the surface emitting laser element of Example 5; and
FIG. 26 illustrates a color printer according to an embodiment of the present invention.

### DETAILED DESCRIPTION OF THE PREFERRED EMBODIMENTS

Experiments conducted by the present inventors on VCSEL elements indicated the following. Doping of the p-side spacer layer of a VCSEL element with a p-type dopant has a large adverse effect on absorption or crystal property. For example, as the doped region is positioned closer to the active region or the amount of doping is increased, the emission characteristics of the VCSEL increasingly degrade (in terms of an increase in the oscillation current threshold, or a decrease in slope efficiency, for example), resulting in lowered reliability.

On the other hand, doping of the n-side spacer layer with an n-type dopant does not have much adverse effect on absorption or crystals. Thus, even if the entire n-side spacer layer is doped or the doped region is extended into the active region, the emission characteristics degrade very little up to a certain doping amount. When the doped region extends into a part of the active region, the element resistance decreases but reliability also decreases. However, the decrease in reliability is small when the doping amount is small. In the present disclosure, the "element resistance" refers to a differential resistance in the I-V curve when the output is 1.4 mW.

### Image Forming Apparatus

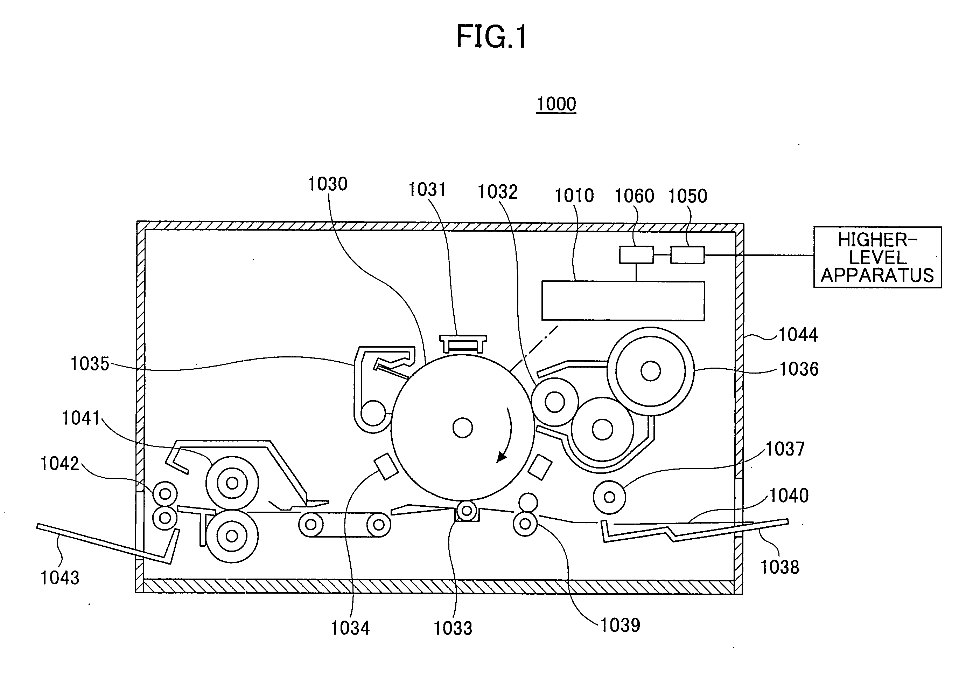

Referring now to the drawings, wherein like reference numerals designate identical or corresponding parts throughout the several views, FIG. 1 illustrates a laser printer 1000 according to an embodiment of the present invention. The laser printer 1000 includes an optical scanning apparatus 1010; a photosensitive drum 1030; a charging unit 1031; a developing roller 1032; a transfer charger 1033; a neutralizing unit 1034; a cleaning unit 1035; a toner cartridge 1036; a sheet-feeding roller 1037; a sheet-feeding tray 1038; a registration roller pair 1039; a fusing roller 1041; a sheet-ejecting roller 1042; an ejected sheet tray 1043; a communication control unit 1050; and a printer control unit 1060 for centrally controlling the above units. These units are disposed within a printer housing 1044.

The communication control unit 1050 is configured to control bidirectional communications with a higher-level apparatus (such as a personal computer) via a network, for example. The photosensitive drum 1030 is a cylindrical component on a surface of which a photosensitive layer is formed. The photosensitive drum 1030 is configured to be rotated in a direction indicated by an arrow.

The charging unit 1031, the developing roller 1032, the transfer charger 1033, the neutralizing unit 1034, and the cleaning unit 1035 are disposed around the photosensitive drum 1030 in an order corresponding to the steps of an image forming process in the laser printer 1000. Specifically, the charging unit 1031 charges the surface of the photosensitive drum 1030 uniformly. The charged surface of the photosensitive drum 1030 is scanned with a light beam emitted from the optical scanning apparatus 1010. The light beam is modulated by image information supplied from the higher-level apparatus. As a result, a latent image is formed on the surface of the photosensitive drum 1030 that corresponds to the image information. The latent image is transported in the direction of the developing roller 1032 as the photosensitive drum 1030 is rotated. The structure of the optical scanning apparatus 1010 is described in detail later.

The toner cartridge 1036 stores toner that is supplied to the developing roller 1032. The developing roller 1032 causes the toner to be attached to the latent image on the surface of the photosensitive drum 1030 in order to develop (i.e., make visible) the image information. The developed image (which may be referred to as a "toner image") is transported in the direction of the transfer charger 1033 as the photosensitive drum 1030 is rotated.

The sheet-feeding tray 1038 stores a number of recording sheets 1040. The sheet-feeding roller 1037 picks out one of the recording sheets 1040 from the sheet-feeding tray 1038 and delivers the recording sheet 1040 to the registration roller pair 1039. The registration roller pair 1039 first retains the recording sheet 1040 and then sends it out into a gap between the photosensitive drum 1030 and the transfer charger 1033 in accordance with the rotation of the photosensitive drum 1030.

The transfer charger 1033 is provided with a voltage of an opposite polarity to the polarity of the toner so that the toner on the surface of the photosensitive drum 1030 can be electrically drawn toward the recording sheet 1040. After the toner image is transferred onto the recording sheet 1040, the recording sheet 1040 is transported to the fusing roller 1041. The fusing roller 1041 applies heat and pressure onto the recording sheet 1040 so as to fuse the toner image onto the recording sheet 1040. The recording sheet 1040 is then transported via the sheet-ejecting roller 1042 to the ejected sheet tray 1043. The surface of the photosensitive drum 1030 is thereafter neutralized by the neutralizing unit 1034. The toner that remains on the surface of the photosensitive drum 1030 is removed by the cleaning unit 1035 before the thus cleaned surface of the photosensitive drum 1030 returns to the position opposite the charging unit 1031.

### Optical Scanning Apparatus

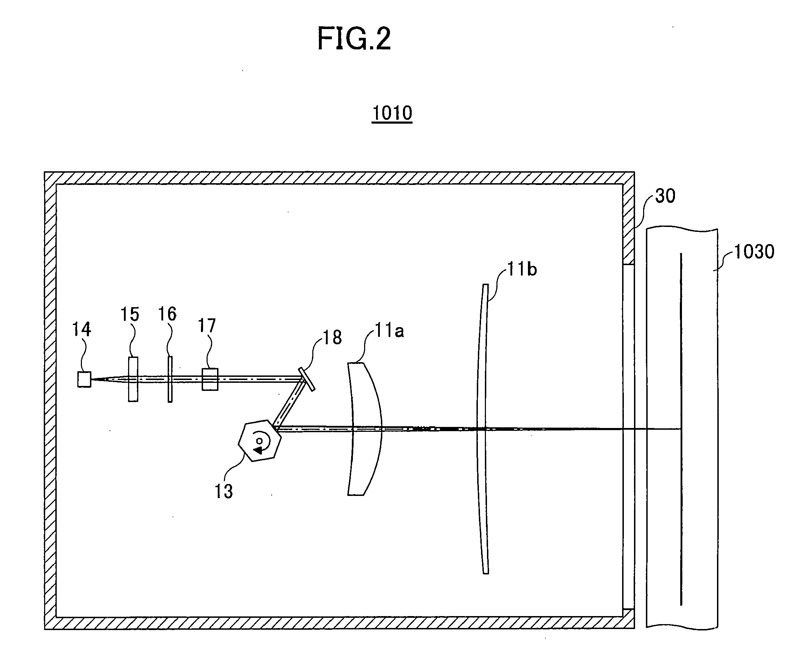

FIG. 2 illustrates the optical scanning apparatus 1010. The optical scanning apparatus 1010 includes a deflector-side scanning lens 11a; an image-side scanning lens 11b; a polygon mirror 13; a light-source unit 14; a coupling lens 15; an aperture plate 16; a cylindrical lens 17; a reflecting mirror 18; and a scan control unit (not shown). These units are disposed within an optical housing 30.

The coupling lens 15 makes a beam of light emitted by the light source 14 into substantially parallel light. The aperture plate 16 includes an aperture portion configured to define a size of the light beam that has passed through the coupling lens 15. The cylindrical lens 17 is configured to focus the light beam that has passed through the aperture portion of the aperture plate 16 in the vicinity of a deflecting/reflecting face of the polygon mirror 13 via the reflecting mirror 18 with respect to a sub-scan direction.

The optical system disposed on the optical path between the light source 14 and the polygon mirror 13 may be referred to as a "pre-deflector optical system". In accordance with the present embodiment, the pre-deflector optical system includes the coupling lens 15, the aperture plate 16, the cylindrical lens 17, and the reflecting mirror 18. The polygon mirror 13 has six deflecting/reflecting faces and may have a diameter of an inscribed circle of 18 mm. The polygon mirror 13 is configured to deflect the light beam from the reflecting mirror 18 while rotating about an axis parallel to the sub-scan direction at constant velocity.

The deflector-side scanning lens 11a is disposed on an optical path of the light deflected by the polygon mirror 13. The image-side scanning lens 11b is disposed on an optical path of the light that has passed through the deflector-side scanning lens 11a. The light that has passed through the image-side scanning lens 11b irradiates the surface of the photosensitive drum 1030, forming a light spot thereon. The light spot is moved in a longitudinal direction of the photosensitive drum 1030 as the polygon mirror 13 rotates, thus scanning the surface of the photosensitive drum 1030 in a main-scan direction.

The optical system disposed on an optical path between the polygon mirror 13 and the photosensitive drum 1030 may be referred to as a scanning optical system. In accordance with the present embodiment, the scanning optical system includes the deflector-side scanning lens 11a and the image-side scanning lens 11b. At least one folding mirror may be disposed on the optical path between the deflector-side scanning lens 11a and the image-side scanning lens 11b, or on the optical path between the image-side scanning lens 11b and the photosensitive drum 1030.

The light source 14 includes a vertical cavity surface emitting laser (VCSEL) element in which laser light is emitted in a direction perpendicular to a substrate of the VCSEL element. The surface emitting laser element may be variously configured or structured, as described in the following with reference to various Examples. In the present disclosure, a direction of laser oscillation is referred to as a Z-axis direction, and two directions perpendicular to each other in a plane normal to the Z-axis direction are referred to as "X-axis direction" and "Y-axis direction" in an XYZ three-dimensional orthogonal coordinate system.

### Example 1

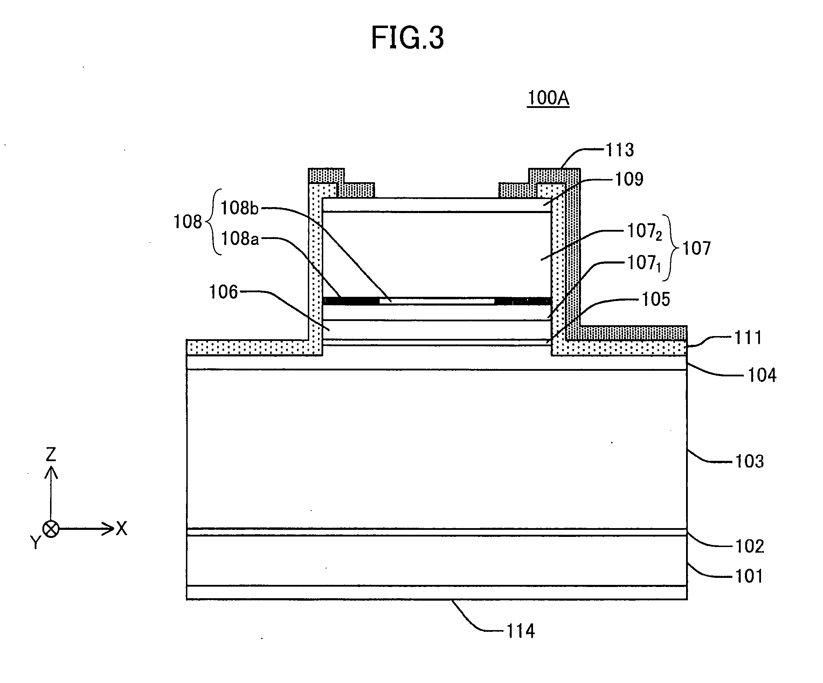

FIG. 3 illustrates a surface emitting laser element 100A according to Example 1, which has an oscillation wavelength of 780 nm band. The surface-emitting laser element 100A includes a substrate 101; a buffer layer 102; a lower semiconductor DBR 103; a lower spacer layer 104; an active layer 105; an upper spacer layer 106; an upper semiconductor DBR 107; a contact layer 109; a p-side electrode 113; and an n-side electrode 114.

The substrate 101 comprises a n-GaAs single crystal substrate. The buffer layer 102 comprises n-GaAs and is stacked on the +Z side of the substrate 101. The lower semiconductor DBR 103 is stacked on the +Z side of the buffer layer 102. The lower semiconductor DBR 103 includes 40.5 pairs of a low-refractive index layer of n-AIAs and a high-refractive index layer of n-Al_{0.3}Ga_{0.7}As. Between the refractive index layers, in order to reduce electric resistance, a graded composition layer of a thickness of 20 nm is provided in which the composition is gradually changed from one composition to another. Each of the refractive index layers has an optical thickness of λ/4 including one half of the adjacent graded composition layers, where λ is the oscillation wavelength. When the optical thickness is λ/4, an actual thickness D of the layer is D=λ/4n (where n is the refractive index of the layer medium).

The lower spacer layer 104 is stacked on the +Z side of the lower semiconductor DBR 103 and comprises (Al_{0.1}Ga_{0.9})_{0.5}In_{0.5}P. The active layer 105 is stacked on the +Z side of the lower spacer layer 104 and includes a triple quantum well structure of GaInAsP/GaInP. The upper spacer layer 106 is stacked on the +Z side of the active layer 105 and comprises (Al_{0.1}Ga_{0.9})_{0.5}In_{0.5}P. A portion including the lower spacer layer 104, the active layer 105, and the upper spacer layer 106 is referred to as a "cavity structure", whose thickness is set to correspond to the optical thickness of a single wavelength. The active layer 105 is disposed at the center of the cavity structure corresponding to an anti-node of the standing wave distribution of an electric field so that a high probability of induced emission can be obtained.

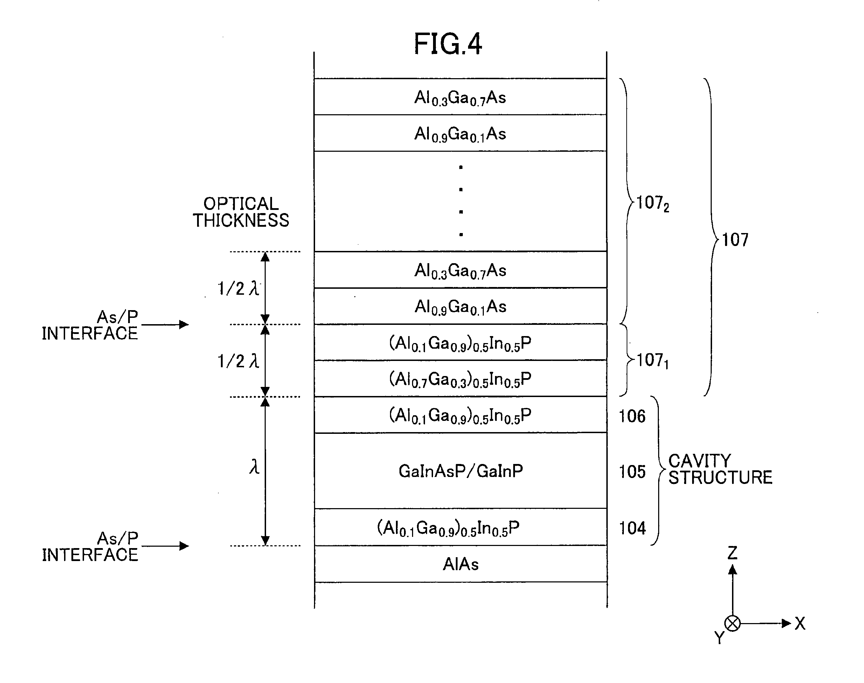

The upper semiconductor DBR 107 includes a first upper semiconductor DBR 107₁ and a second upper semiconductor DBR 107₂, as illustrated in FIG. 4. The first upper semiconductor DBR 107₁ is stacked on the +Z side of the upper spacer layer 106 and includes a pair of a low-refractive index layer of p-(Al_{0.7}Ga_{0.3})_{0.5}In_{0.5}P and a high-refractive index layer of p-(Al_{0.1}Ga_{0.9})_{0.5}In_{0.5}P. Between these low- and high-refractive index layers, a buffer layer having a constant composition is provided in order to reduce electric resistance. Each of the refractive index layers has an optical thickness of λ/4 including one half of the adjacent buffer layer. The first upper semiconductor DBR 107₁ has bandgap energy greater than that of the AlGaAs layer, thus functioning as a blocking layer for the electrons injected into the active region.

The second upper semiconductor DBR 107₂ is stacked on the +Z side of the first upper semiconductor DBR 107₁ and includes 24 pairs of a low-refractive index layer of pAl_{0.9}Ga_{0.1}As and a high-refractive index layer of p-Al_{0.3}Ga_{0.7}As. Between these low- and high-refractive index layers, there is disposed a graded composition layer in which the composition is gradually varied from one composition to another composition in order to reduce electric resistance. Each of the refractive index layers has an optical thickness of λ/4 including one half of the adjacent graded composition layers.

In one of the low-refractive index layers of the second upper semiconductor DBR 107₂, a selectively oxidized layer 108 of p-AIAs having a thickness of 33 nm is inserted. Specifically, the selectively oxidized layer 108 is inserted at a position corresponding to the third node from the active layer 105 in the standing wave distribution of an electric field. Thus, the portion that generates heat due to the increase in resistance caused by current confinement can be located away from the active layer 105 while a practical threshold current can be maintained. Further, thermal resistance can be reduced, and the local heating of the central portion of the element can be reduced. Further, the influence of strain on the active layer 105 due to selective oxidation of the selectively oxidized layer 108 can be reduced, so that the lifespan of the element can be increased. The contact layer 109 is stacked on the +Z side of the second upper semiconductor DBR 107₂ and comprises p-GaAs.

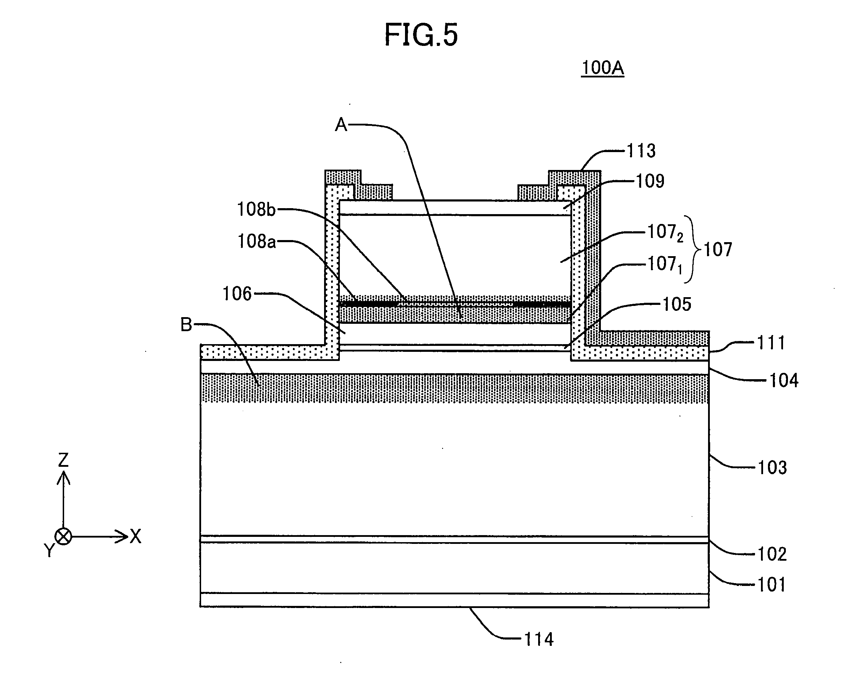

In some of the layers of the upper semiconductor DBR 107 in a region closer to the cavity structure, the doping concentration of a p-type dopant is controlled to be lower than in the other regions. The p-type dopant may include C from carbon tetrabromide (CBr₄) as a raw material. Specifically, in the upper semiconductor DBR 107, four of the pairs in a region adjacent the upper spacer layer 106 form a low-doping concentration area A having a lower doping concentration than the doping concentration of the remaining 21 pairs, as illustrated in FIG. 5. The doping concentration may be in a range between 5×10¹⁷ and 1×10¹⁸ atoms/cm³ for the low-doping concentration area and between 1.5×10¹⁸ and 5×10¹⁸ atoms/cm³ for the remaining 21 pairs.

In some of the layers of the lower semiconductor DBR 103 in a region closer to the cavity structure, the doping concentration of a n-type dopant is adjusted to be lower than in the other regions. The n-type dopant may include Se from hydrogen selenide (H₂Se) as a raw material. Specifically, in the lower semiconductor DBR 103, four of the pairs in a region adjacent the lower spacer layer 104 form a low-doping concentration area B having a lower doping concentration than that of the remaining 36.5 pairs, as illustrated in FIG. 5. The doping concentration may be in a range between 5×10¹⁷ and 1×10¹⁸ atoms/cm³ for the low-doping concentration region and between 1.5×10¹⁸ and 3×10¹⁸ atoms/cm³ for the remaining 36.5 pairs. Thus, in the upper and the lower semiconductor DBRs 107 and 103, the portions adjacent the cavity structure have lower doping concentrations.

The standing wave intensity of light in the upper and the lower semiconductor DBRs 107 and 103 is reduced in half approximately four pairs away from the active layer 105. Thus, by setting the doping concentration of the region having a high intensity distribution to a lower value, free carrier absorption can be effectively reduced. As a result, the loss by free carrier absorption (which may be referred to as an "absorption loss") decreases, so that the oscillation threshold current can be reduced and slope efficiency can be improved. Thus, the element drive current and therefore the required power can be reduced, leading to a decrease in the emission of heat.

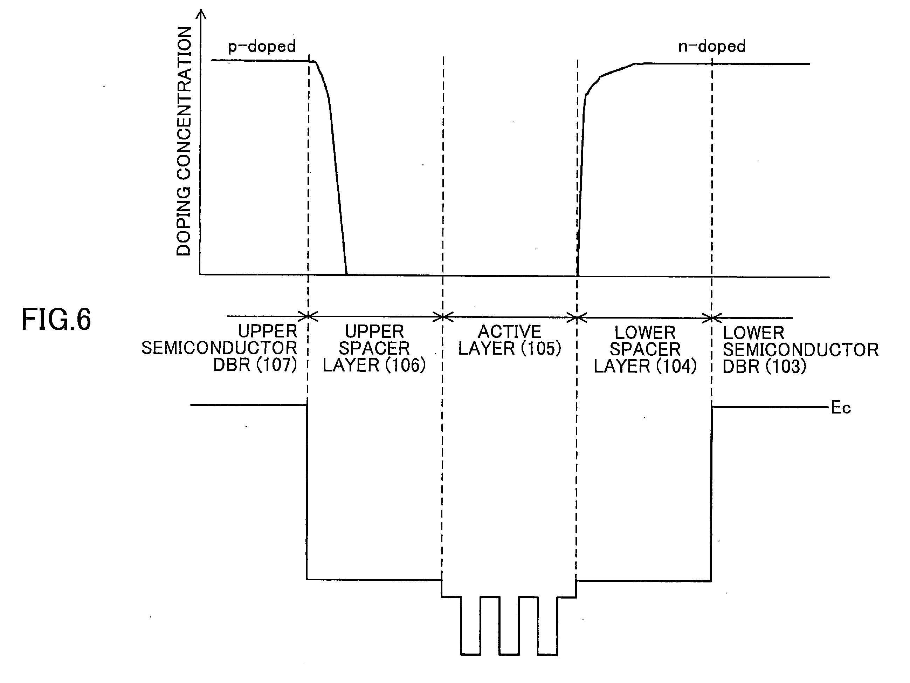

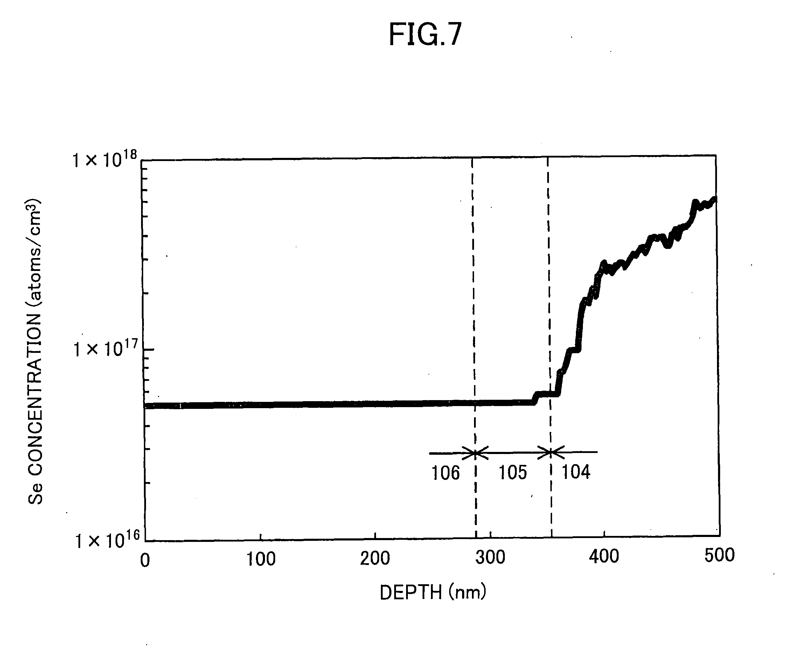

The lower spacer layer 104 is doped with an n-type dopant (see FIGs. 6 and 7), which may include Se from hydrogen selenide (H₂Se) as a raw material. The doping concentration may be in a range between 5×10¹⁷ and 1×10¹⁸ atoms/cm³. FIG. 7 illustrates a result of measurement of the concentration of the Se dopant by a secondary ion mass spectrometer (SIMS). The upper spacer layer 106 is almost entirely un-doped with the exception of a portion adjacent the upper semiconductor DBR 107 having a thickness on the order of several dozen nanometers, in which the n-type dopant diffused from the upper semiconductor DBR 107 is contained (see FIG. 6).

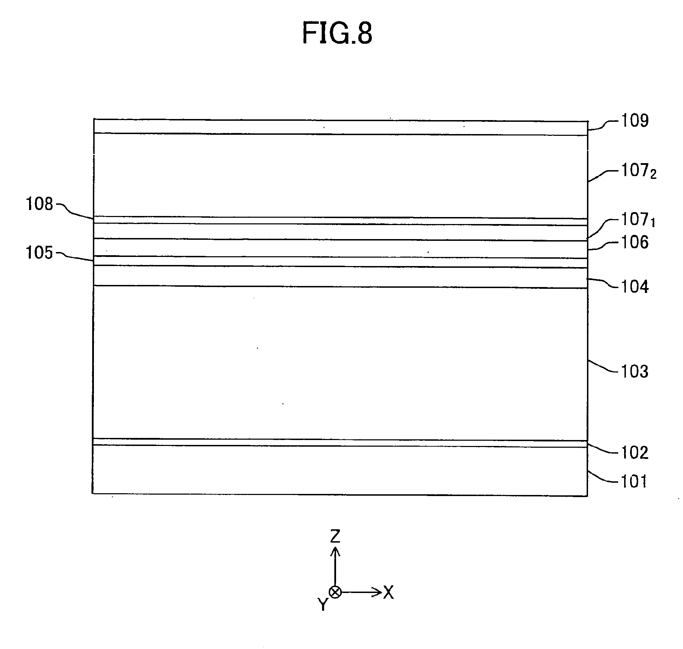

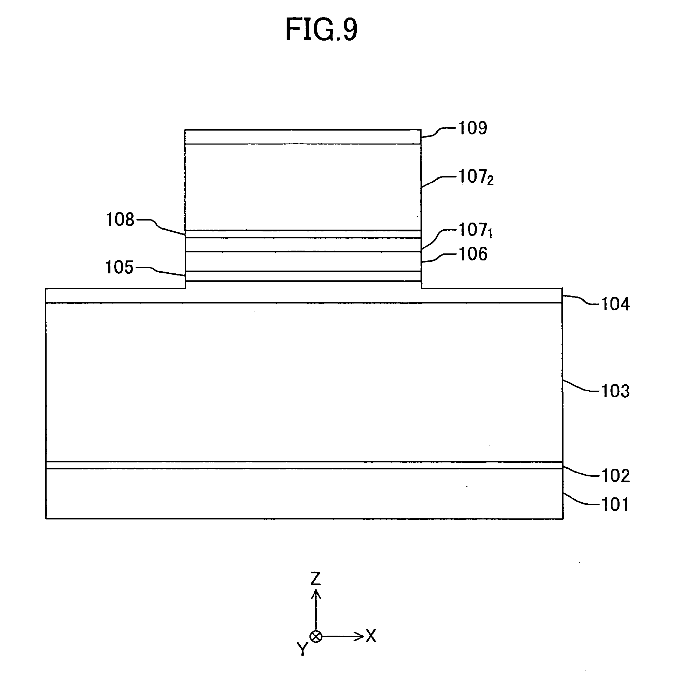

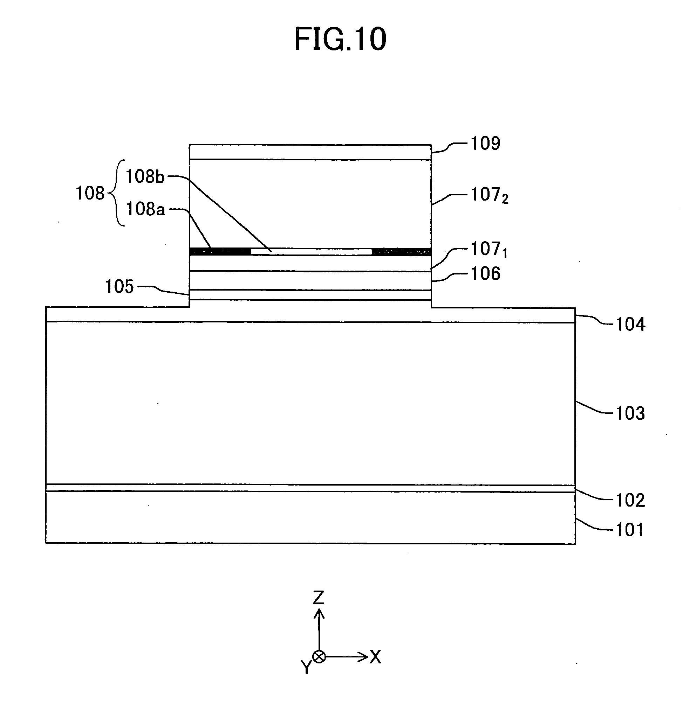

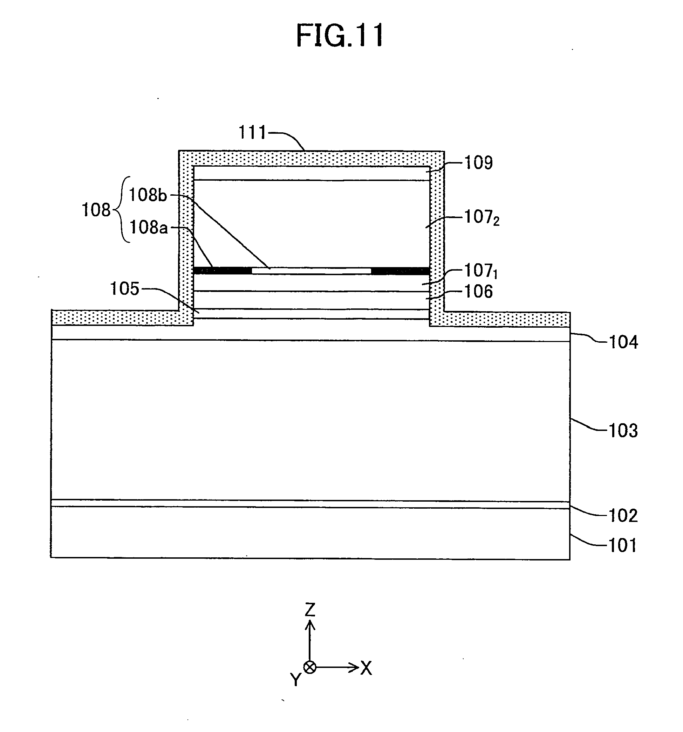

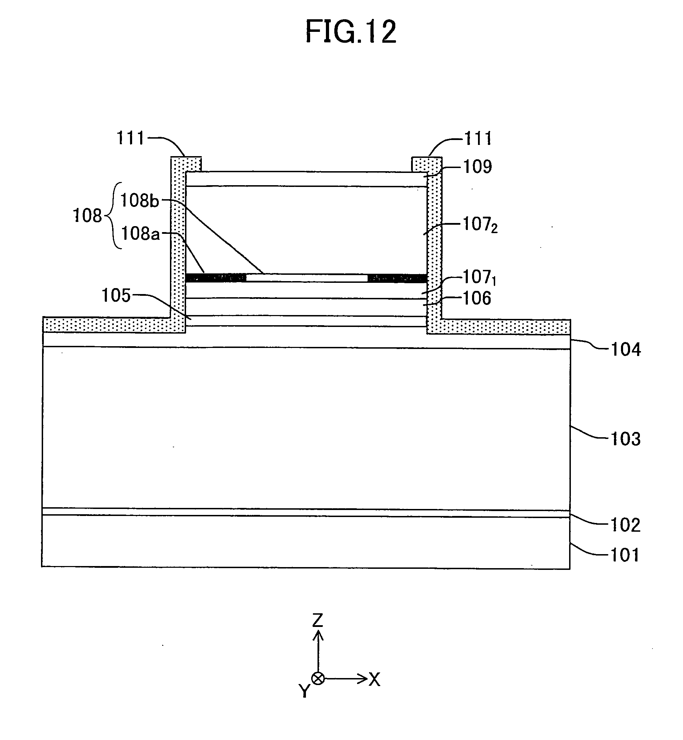

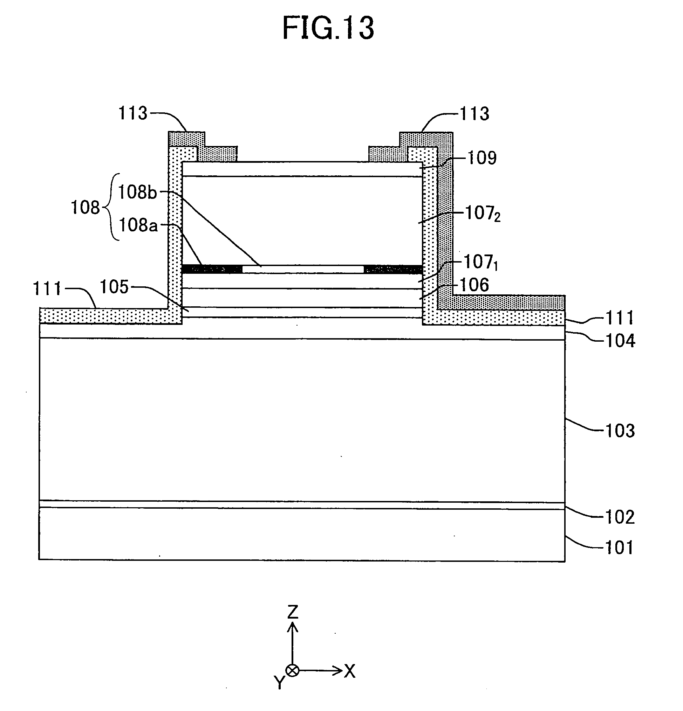

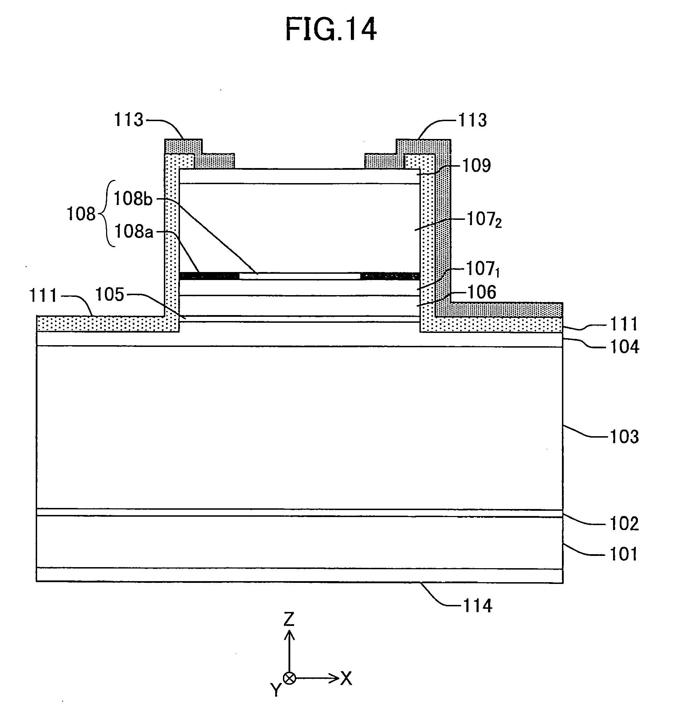

Next, a method of manufacturing the surface emitting laser element 100A is briefly described. The semiconductor layers stacked on the substrate 101 as described above may be referred to as a "stacked body".
(1) The stacked body is prepared by a crystal growth method, such as metal organic chemical vapor deposition (MOCVD) or molecular beam epitaxy (MBE) (see FIG. 8). In the case of MOCVD, the Group III material may include trimethylaluminium (TMA), trimethylgalium (TMG), or trimethylindium (TMI), and the Group V material may include phosphine (PH₃) or arsine (AsH₃).
(2) A resist pattern of a square shape having a length of 25 µm in each side is formed on a surface of the stacked body.
(3) Using ECR etching process involving Cl₂ gas, and using the resist pattern as a photomask, a square-pillar shaped mesa structure (which may be referred to simply as a "mesa") is formed, where an etched bottom is located within the lower spacer layer 104.
(4) The photomask is removed (see FIG. 9).
(5) The stacked body is heat-processed in the presence of water vapor in order to selectively oxidize Al (aluminum) in the selective oxidization layer 108 from the periphery of the mesa, leaving a region 108b at the center of the mesa that is not oxidized and surrounded by an Al oxidized layer 108a (see FIG. 10). Thus, an oxidized confinement structure is formed that limits the passage of a drive current for the light-emitting portion to within the central portion of the mesa. The un-oxidized region 108b forms a current passage region (current injection region). In this way, a substantially square-shaped current passage region having a width of approximately 4 µm is formed.
(6) By chemical vapor deposition (CVD), the protection layer 111 of SiN is formed (see FIG. 11).
(7) An etching mask M is prepared for forming a p-side electrode contact window on a mesa upper-part that forms a laser light emitting surface.
(8) The protection layer 111 is etched by BHF, thereby opening a window for the p-side electrode contact.
(9) The mask M is removed (see FIG. 12).
(10) A square-shaped resist pattern measuring 10 µm in each side is formed in a region on the mesa upper-part that forms an emission area, and a p-side electrode material is deposited. The p-side electrode material may include a multilayer film of Cr/AuZn/Au or Ti/Pt/Au.
(11) The electrode material deposited in the emission area is lifted off, thus forming the p-side electrode 113 (see FIG. 13). The region surrounded by the p-side electrode 113 forms the emission area.
(12) After a back surface of the substrate 101 is ground to a predetermined thickness (such as on the order of 100 µm), the n-side electrode 114 is formed (see FIG. 14). The n-side electrode 114 may include a multilayer film of AuGe/Ni/Au.
(13) Ohmic contact is provided between the p-side electrode 113 and the n-side electrode 114 by annealing, thus enabling the mesa to emit light.
(14) The substrate is cut into individual laser chips.

After various post-processes, the surface-emitting laser element 100A is obtained. Thus, the entire lower spacer layer 104 is doped in order to reduce element resistance. By providing an undoped region in the upper spacer layer 106 closer to the active layer 105, degradation of emission characteristics is prevented.

An accelerated aging test of the surface emitting laser element 100A indicated a lifespan similar to that of conventional surface emitting laser elements. Thus, the surface emitting laser element 100A is sufficiently reliable, and hardly any adverse effect was observed of the doping of the area near the active layer 105 with Se.

The interface quality of an As/P interface tends to degrade easily into an interface having a number of defect states. If the As/P interface is provided at the boundary between the cavity structure and the upper semiconductor DBR 107₁, the influence of light absorption may increase due to the strong electric field, resulting in a decrease in emission efficiency. Further, some of the electrons injected into the active layer may overflow and be coupled with the defect states, resulting in a decrease in emission efficiency.

In the surface emitting laser element 100A according to the present embodiment, the upper semiconductor DBR 107₁ includes the pair of the high- and low-refractivity layers of p-(A_{0.7}Ga_{0.3})_{0.5}In_{0.5}P/p-(Al_{0.1}Ga_{0.9})_{0.5}In_{0.5}P adjacent the active layer. Thus, the p-side As/P interface is located away from the cavity structure (see FIG. 4) and the overflow of electrons can be blocked, so that the decrease in emission efficiency is prevented. The position of the p-side As/P interface is not particularly limited and may be varied in accordance with the particular design.

Measurement of the element resistance of the surface emitting laser element 100A indicated a value of 245 Ω. This contrasted with the element resistance of about 310 Ω of a conventional surface emitting laser element in which the lower spacer layer is not doped with an n-type dopant intentionally. The n-type dopant is not limited to Se and may include Si or S, for example.

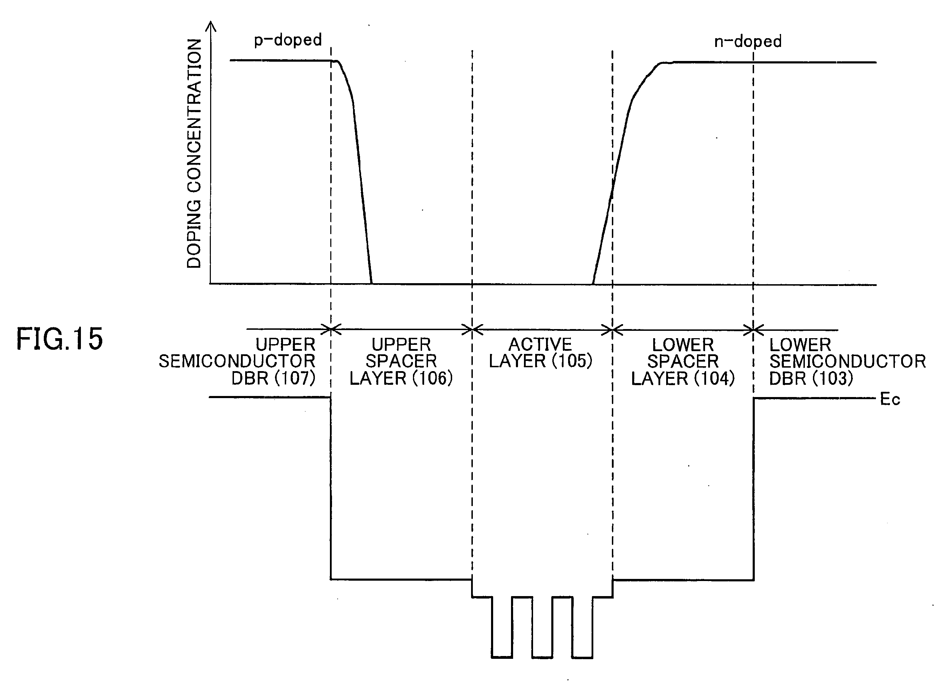

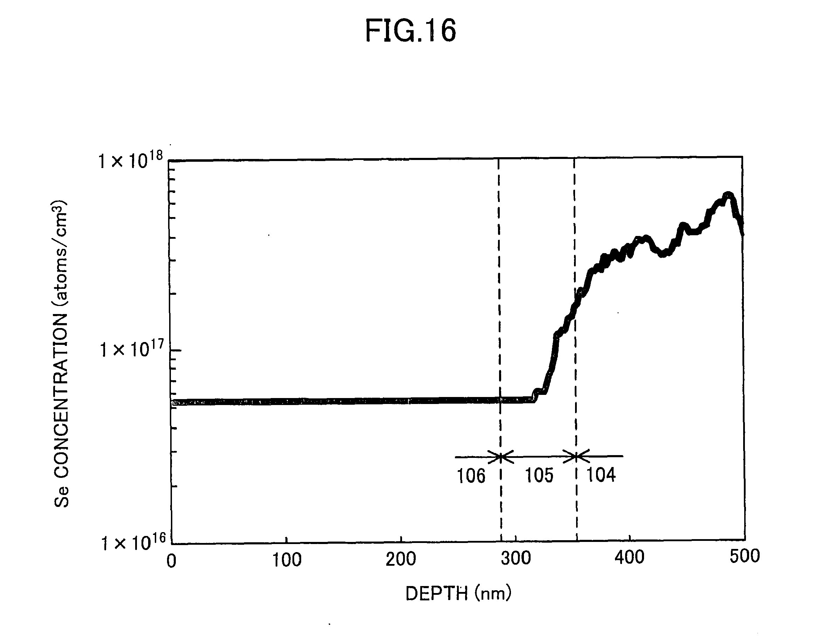

In a variation of the surface emitting laser element 100A, a surface emitting laser element 100B was prepared having a structure similar to that of the surface emitting laser element 100A and in which Se was doped into the active layer 105. Measurement of the element resistance of the surface-emitting laser element 100B indicated a value of 235 Ω (see FIG. 15), which is a 10 Ω decrease compared to the surface emitting laser element 100A. The concentration of Se in the active layer 105 was controlled to be below 1×10¹⁷ atoms/cm³ according to measurement by a secondary ion mass spectrometer (SIMS) as indicated in FIG. 16. In terms of lifespan and emission characteristics, no significant difference was observed between the surface emitting laser elements 100B and 100A.

Thus, when Se is doped not just in the lower spacer layer 104 but also into the active layer 105, element resistance and reliability can be balanced by adjusting the range and concentration of doping in the active layer.

### Example 2

A surface emitting laser element 100C according to Example 2 has an oscillation wavelength in a 780 nm band. The surface-emitting laser element 100C differs from the surface emitting laser element 100A in that the upper and the lower spacer layers comprise Ga_{0.5}In_{0.5}P. In the surface emitting laser element 100C, element resistance is lowered as in the surface emitting laser element 100A without lowering the emission characteristics. The surface emitting laser element 100C can be manufactured in a process similar to the process for the surface emitting laser element 100A.

Because the spacer layers of GaInP have a larger heat conductivity than the spacer layers of AlGaInP that contain Al, improvement in heat dissipation from the element can be expected. Such an improvement in heat dissipation enables a decrease in the temperature of the active layer during operation, resulting in an increase in emission efficiency and element lifespan. Thus, the composition of the spacer layers may be modified according to the particular design.

### Example 3

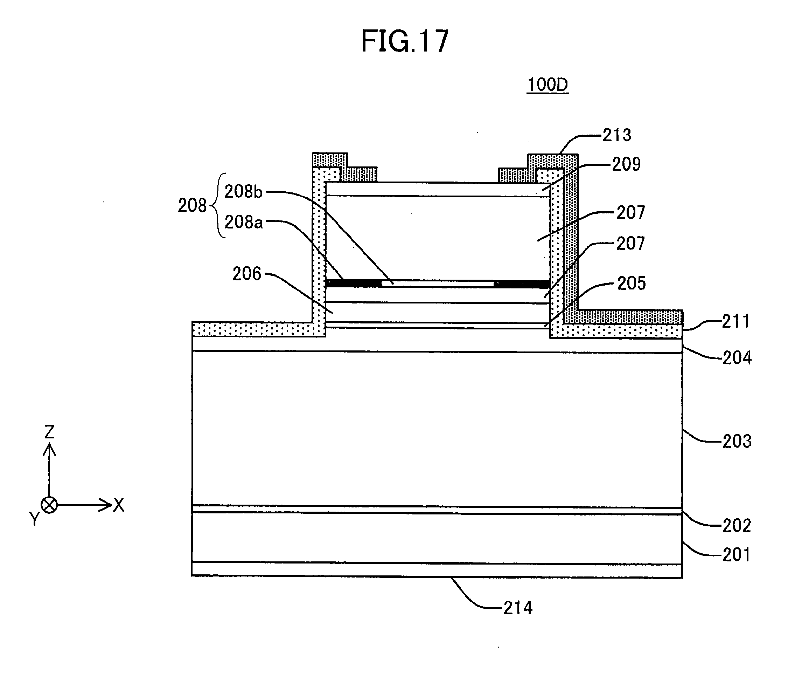

FIG. 17 illustrates a surface emitting laser element 100D according to Example 3, which has an oscillation wavelength in the 780 nm band. The surface-emitting laser element 100D includes a substrate 201; a buffer layer 202; a lower semiconductor DBR 203; a lower spacer layer 204; an active layer 205; an upper spacer layer 206; an upper semiconductor DBR 207; a contact layer 209; a p-side electrode 213; and an n-side electrode 214.

The substrate 201 comprises a n-GaAs single crystal substrate. The buffer layer 202 comprises n-GaAs and is stacked on the +Z side of the substrate 201. The lower semiconductor DBR 203 is stacked on the +Z side of the buffer layer 202. The lower semiconductor DBR 103 includes 40.5 pairs of a low-refractive index layer of n-AIAs and a high-refractive index layer of n-Al_{0.3}Ga_{0.7}As. In order to reduce electric resistance, a graded composition layer of a thickness of 20 nm in which the composition is gradually changed from one composition to another is provided between the refractive index layers. Each of the refractive index layers has an optical thickness of λ/4 including one half of the adjacent graded composition layers, where λ is the oscillation wavelength.

The lower spacer layer 204 is stacked on the +Z side of the lower semiconductor DBR 203 and comprises (Al_{0.1}Ga_{0.9})_{0.5}In_{0.5}P. The active layer 205 is stacked on the +Z side of the lower spacer layer 204 and includes a triple quantum well structure of GaInAsP/GaInP. The quantum well layer comprises a GaInP mixed crystal into which As is introduced in order to obtain an oscillation wavelength of the 780 nm band. The quantum well layer has a compressive strain of 0.7%. A barrier layer is provided with a tensile strain of 0.6% in order to increase the bandgap and realize a high carrier-confining effect, while forming a strain-compensating structure for the quantum well layer. The upper spacer layer 206 is stacked on the +Z side of the active layer 205 and comprises (Al_{0.1}Ga_{0.9})_{0.5}In_{0.5}P.

The portion including the lower spacer layer 204, the active layer 205, and the upper spacer layer 206 is referred to as a cavity structure whose optical thickness is set to correspond to a single wavelength. The active layer 205 is disposed at the center of the cavity structure corresponding to an anti-node of the standing wave distribution of an electric field so that a high probability of stimulated emission can be obtained.

The upper semiconductor DBR 207 is stacked on the +Z side of the upper spacer layer 206 and comprises 25 pairs of a low-refractive index layer of p-Al_{0.9}Ga_{0.1}As and a high-refractive index layer of p-Al_{0.3}Ga_{0.7}As. In order to reduce electric resistance, a graded composition layer is provided between the refractive index layers in which the composition is gradually changed from one composition to another. Each of the refractive index layers has an optical thickness of λ/4 including one half of the adjacent inclined compositions. In one of the low-refractive index layers in the upper semiconductor DBR 207, a selective oxidization layer 208 of p-AlAs having a thickness of 33 nm is inserted. Specifically, the selective oxidization layer 208 is inserted at a position corresponding to the third node from the active layer 205 in the standing wave distribution of an electric field. In this way, the portion that is heated by the increase in resistance caused by current confinement can be located away from the active layer, while maintaining a practical threshold current. Further, thermal resistance can be reduced, so that the localized heating of the element central portion can be reduced. Furthermore, the influence of strain on the active layer due to the selective oxidation of the selectively oxidized layer 208 can be reduced, so that the element lifespan can be increased. The contact layer 209 is stacked on the +Z side of the upper semiconductor DBR 207 and comprises p-GaAs.

In some of the layers in the upper semiconductor DBR 207 in a region closer to the cavity structure, the doping concentration of a p-type dopant is adjusted to be lower than in the other regions. The p-type dopant may include C from carbon tetrabromide (CBr₄) as a raw material. Specifically, four of the pairs in the upper semiconductor DBR 207 in a region adjacent the upper spacer layer 206 form a low-doping concentration area having a lower doping concentration than the doping concentration of the remaining 21 pairs. More specifically, the doping concentration may be in a range between 5×10¹⁷ and 1×10¹⁸ atoms/cm³ for the low-doping concentration area and between 1.5×10¹⁸ and 5×10¹⁸ atoms/cm³ for the remaining 21 pairs.

In some of the layers in the lower semiconductor DBR 203 in a region closer to the cavity structure, the doping concentration of an n-type dopant is adjusted to be lower than in the other regions. The n-type dopant may include Se from hydrogen selenide (H₂Se) as a raw material. Specifically, four of the pairs in a region of the lower semiconductor DBR 203 adjacent the lower spacer layer 204 form a low-doping concentration area having a lower doping concentration than the doping concentration of the remaining 36.5 pairs. Specifically, the doping concentration may be in a range between 5×10¹⁷ and 1×10¹⁸ atoms/cm³ for the low-doping concentration area and between 1.5×10¹⁸ and 3×10¹⁸ atoms/cm³ for the remaining 36.5 pairs. Thus, in each semiconductor DBR, the doping concentration is lowered in a portion adjacent the cavity structure.

The standing wave intensity of light in the semiconductor DBR is reduced in half about four pairs away from the active layer. Thus, by setting the doping concentration in the large intensity distribution region at a lower value, free carrier absorption can be effectively reduced. The decrease in absorption loss enables a decrease in the oscillation threshold current, whereby slope efficiency can be improved and the element drive current can be reduced. As a result, the required power and resulting heat generation can be reduced.

The lower spacer layer 204 is doped with an n-type dopant, which may include Se from hydrogen selenide (H₂Se) as a raw material. Specifically, the doping concentration may be in a range between 5×10¹⁷ and 1×10¹⁸ atoms/cm³. The upper spacer layer 206 is almost entirely un-doped, except for a portion having a thickness on the order of several dozen nm adjacent the upper semiconductor DBR 207 in which the n-type dopant diffused from the upper semiconductor DBR 207 is contained.

The element resistance of the surface emitting laser element 100D is reduced as in the surface emitting laser element 100A without degrading the emission characteristics. The surface emitting laser element 100D can be manufactured by a process similar to the process for the surface emitting laser element 100A.

Numeral 208a in FIG. 17 designates an Al oxidized layer formed by the selective oxidation of Al in the selectively oxidized layer 208. Numeral 208b designates a current passage area. Numeral 211 designates a protection layer of SiN.

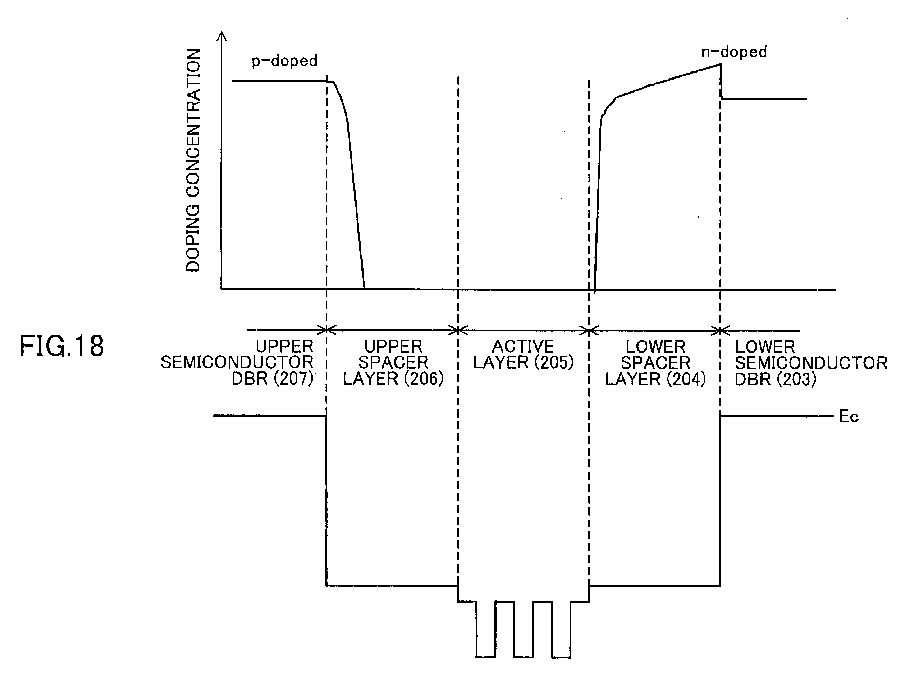

In the surface emitting laser element 100D, the doping amount of Se in the lower semiconductor DBR 203 may be about 5×10¹⁷ atoms/cm³, while the doping amount of Se in the portion of the lower spacer layer 204 adjacent the lower semiconductor DBR 203 may be in a range between 8×10¹⁷ and 1×10¹⁸ atoms/cm³. Namely, as illustrated in FIG. 18, at and near the interface between the lower spacer layer 204 and the lower semiconductor DBR 203, the doping amount of Se may be greater on the side of the lower spacer layer 204 than on the side of the lower semiconductor DBR 203. In this way, the resistance at the As/P interface, which is a main factor for an increase in element resistance, can be reduced while maintaining a low doping concentration in other portions where a large doping amount is undesirable, so that satisfactory characteristics can be obtained while achieving a decrease in resistance.

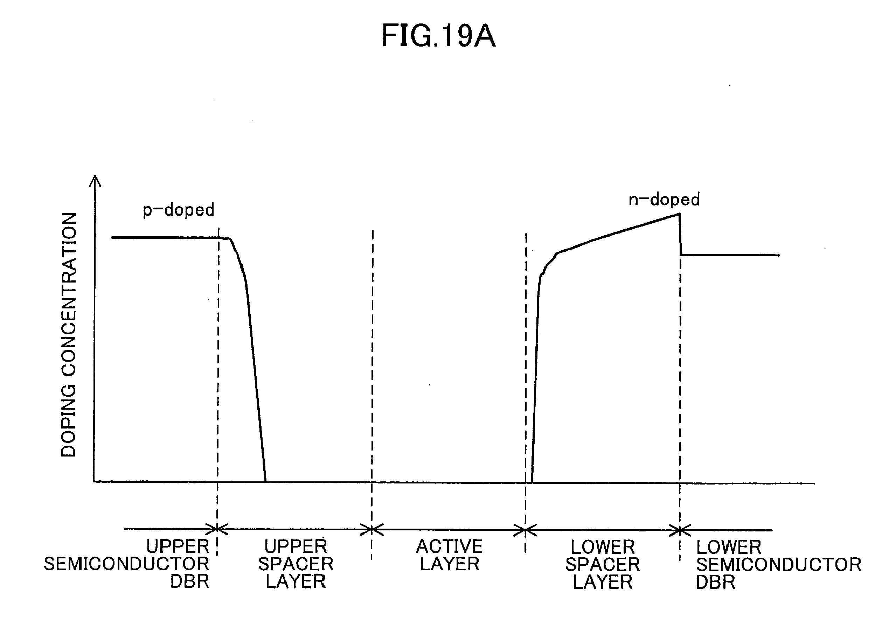

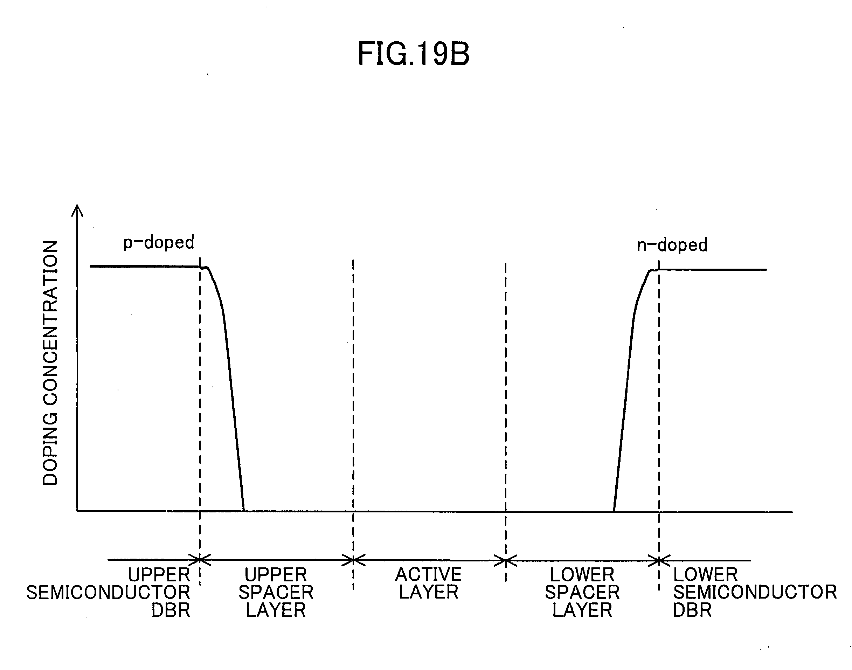

Experiments conducted by the inventors provided the following insights:
1. Because the interface between the spacer layer and the semiconductor DBR corresponds to the interface between the resonator and the reflector, there is a strong electric field at the interface. Thus, an increase in doping amount in the interface portion may lead to the problem of light absorption. In an experiment, two cases were compared. In a first case, the doping concentration was higher on the side of a lower spacer layer of (AlₓGa₍₁₋ₓ₎ )_{z}In_{(1-z})P (where 0 ≤x ≤1,0 ≤z ≤1) than on the side of a lower semiconductor DBR of Al_{w}Ga_{(1-w)}As (where 0 ≤w ≤1) at and near the interface, as illustrated in FIG. 19A. In a second case, the doping concentration at and near the interface was equal between the side of the lower semiconductor DBR and the side of the lower spacer layer, as illustrated in FIG. 19B.

In the first case, the doping concentration is higher on the side of the lower spacer layer at and near the interface and, in addition, the lower spacer layer is generally entirely doped. On the other hand, in the second case, the doped region is limited to a portion of the lower spacer layer. Even under these conditions, which were presumed to provide different light absorption properties, not much decrease in characteristics was observed in the first case compared to the second case.
2. AlGaAs materials tend to contain C (carbon) particularly in the case of metal organic chemical vapor deposition (MOCVD), and the presence of C was observed at the As/P interface. If the lower spacer layer is un-doped or low-doped, the interface tends to be locally rendered p-type due to the presence of C (carbon) in the interface between the lower spacer layer and the lower semiconductor DBR, resulting in an increase in resistance. Thus, by increasing the doping concentration in the lower spacer layer near the interface with the lower semiconductor DBR, the interface between the lower spacer layer and the lower semiconductor DBR can be prevented from being locally rendered p-type, thereby lowering resistance.

Such a doping scheme is preferable to the opposite doping scheme where the lower semiconductor DBR of Al_{w}Ga_{(1-w)}As (where 0 ≤w ≤1) is doped with a higher concentration than in the lower spacer layer of (AlₓGa₍₁₋ₓ₎)_{z}In_{(1-z)}P (where 0 ≤x ≤1, 0 ≤z ≤1). The reason is that, when a P (phosphor)-based material is grown on an As-based material, while the As-based material may be easily grown at high quality, the P-based material, which is grown immediately after switching to a group V gas, tends to contain defects, resulting in a layer with lowered crystal quality and an increase in resistance. Thus, it is more effective to increase the doping concentration on the side of the P-based material (lower spacer layer) than the side of the As-based material (lower semiconductor DBR) in lowering resistance.

Thus, by increasing the doping concentration of a portion of the lower spacer layer, which contains P (phosphor) as the group V material, adjacent and near the interface with the lower semiconductor DBR compared to the AlGaAs layer of the lower semiconductor DBR, the resistance of the interface on the P-based material side, which tends to exhibit a high resistance, can be lowered. As a result, a surface emitting laser element can be provided that has a low element resistance and is capable of high-speed optical modulation.

It has also been experimentally shown that the element resistance of the surface emitting laser element can be further lowered and high-speed optical modulation can be performed by doping the entire lower spacer layer with an n-dopant. Related-art literature is abundant with reports of surface-emitting laser elements in which the cavity structure is not doped. A surface emitting laser element has also been reported in which both the upper spacer layer and the lower spacer layer are doped, as disclosed in Patent Document 2. However, no report has been made about a surface emitting laser element in which the doping concentration is higher in the lower spacer layer of (AlₓGa₍₁₋ₓ₎)_{z}In_{(1-z)}P (where 0 ≤x ≤1, 0 ≤z ≤1) than in the adjacent lower semiconductor DBR of Al_{w}Ga_{(1-w)}As (where 0 ≤w ≤1). Experiments conducted by the inventors indicated that in this case, the optical modulation speed can be increased and the element characteristics and reliability can be satisfied because of a sufficient decrease in the element resistance.

Thus, in the surface emitting laser elements 100A, 100B, 100C, and 100D according to the embodiments of the present invention, a lower semiconductor DBR, a lower spacer layer, an active layer, an upper spacer layer, and an upper semiconductor DBR are stacked on a substrate. The active layer is disposed between the lower spacer layer (n-side spacer layer) and the upper spacer layer (p-side spacer layer). The upper spacer layer includes an undoped region adjacent the active layer in which no p-type dopant is contained, while the entire lower spacer layer is doped with an n-type dopant. In this structure, the element resistance can be reduced without lowering the emission characteristics.

In the optical scanning apparatus 1010, the light source 14 includes one of the surface emitting laser elements 100A, 100B, 100C, or 100D. Thus, the optical scanning apparatus 1010 can perform a highly accurate optical scanning operation. The laser printer 1000 includes the optical scanning apparatus 1010, so that the laser printer 1000 can form a high-quality image. The material of the protection layer is not limited to SiN and may include SiNₓ, SiOₓ, TiOₓ, or SiON.

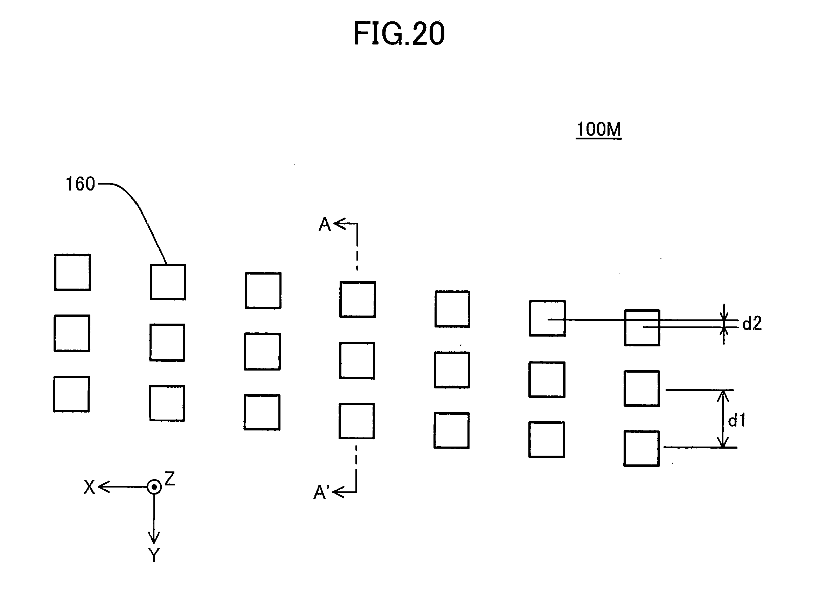

The light source 14 may include a surface emitting laser array 100M illustrated in FIG. 20, instead of one of the surface emitting laser elements 100A, 100B, 100C, or 100D. The surface emitting laser array 100M includes plural (21 in the illustrated example) light-emitting portions 160 disposed on the same substrate. The light-emitting portions 160 are arranged two-dimensionally at regular intervals d2 when viewed in an orthographic projection of all of the light-emitting portions 160 on a virtual line extending in a Y-axis direction. The regular intervals d2 may be referred to as "the emitting portion interval", i.e., the distance between the centers of two adjacent emitting portions 160 in the orthographic projection. The number of the light-emitting portions is not limited to 21.

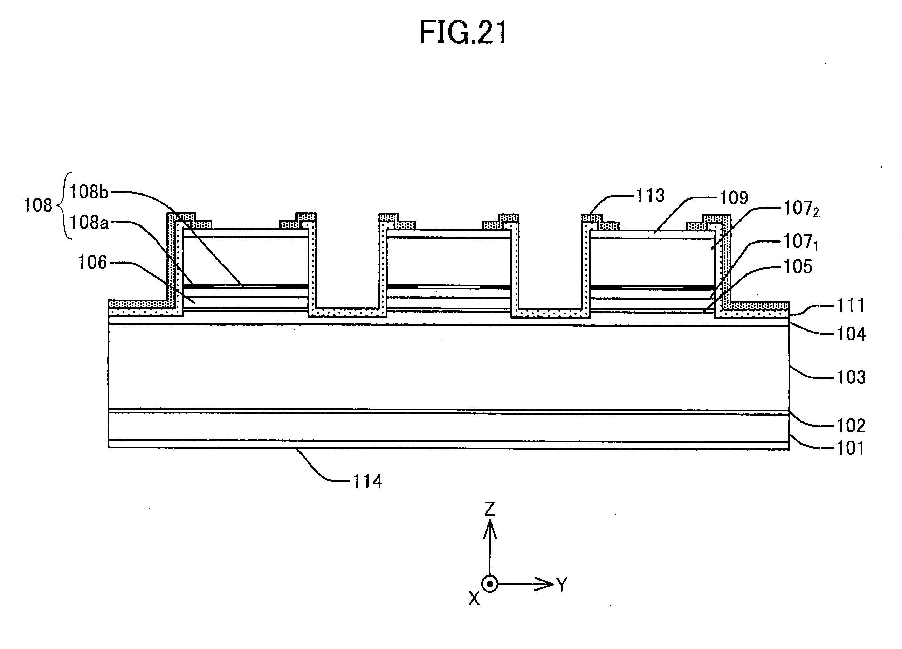

FIG. 21 is a cross section taken along line A-A' of FIG. 20. As illustrated, each of the light emitting portions of the surface-emitting laser array 100M has a structure similar to that of the surface emitting laser element 100A. Thus, the surface emitting laser array 100M may be manufactured in a process similar to the process for manufacturing the surface emitting laser element 100A, so that the element resistance can be reduced without degrading the emission characteristics. The light-emitting portions may have the same structure as that of one of the surface emitting laser elements 100B, 100C, or 100D. Because the light-emitting portions 160 are arranged at the regular intervals d2 when viewed in the orthographic projection, the same effect can be obtained as if the light-emitting portions 160 are arranged at regular intervals in the sub-scan direction on the photosensitive drum 1030 by adjusting the timing of lighting of the light-emitting portions 160.

For example, a high-density write operation of 4800 dpi (dots per inch) can be performed by setting the interval d2 at 2.65 µm and doubling the magnification factor of the optical system of the optical scanning apparatus 1010. It goes without saying that the write density can be further increased by increasing the number of the light-emitting portions 160 in the main-scan direction, by further reducing the interval d2 by narrowing a pitch d1 in the sub-scan direction (see FIG. 20), or increasing the magnification factor of the optical system, thereby enabling higher quality printing. A write interval in the main-scan direction can be easily controlled via the timing of lighting of the light-emitting portions 160. Thus, the laser printer 1000 can perform the printing operation without a decrease in printing speed even though the write dot density is increased. This means that the printing speed can be increased further for the same write dot density.

In any of the foregoing embodiments, the surface emitting laser element 100A, 100B, 100C, or 100D may be replaced with a surface emitting laser array in which light-emitting portions similar to those of the surface emitting laser element 100A, 100B, 100C, or 100D are one-dimensionally arranged.

The oscillation wavelength of the emitting portion is not limited to the 780 nm band according to the foregoing embodiments and may be changed depending on the characteristics of the photosensitive material, for example.

### Example 4

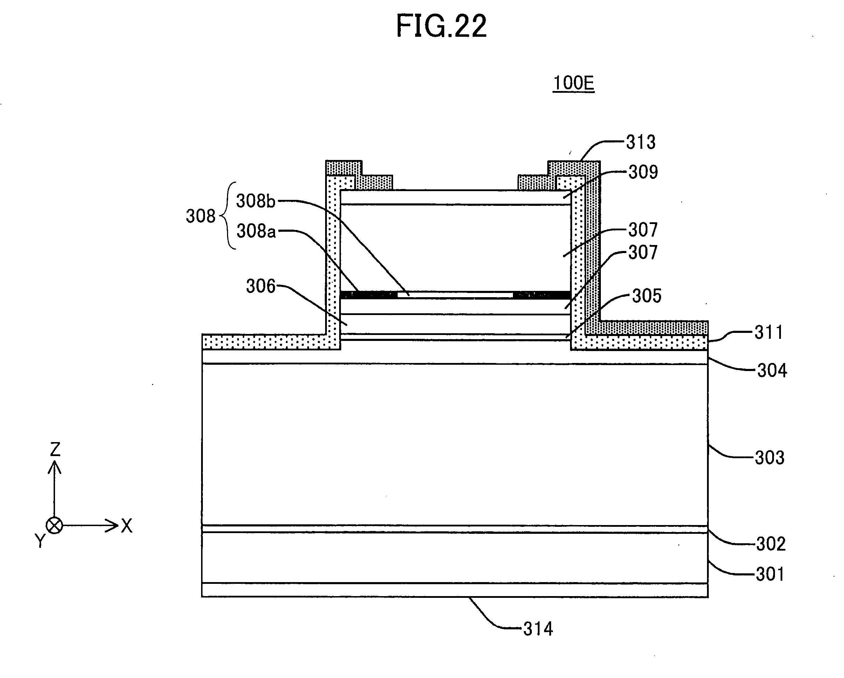

FIG. 22 illustrates a surface emitting laser element 100E configured to emit an oscillation wavelength in a 660 nm band. The surface-emitting laser element 100E includes a substrate 301; a buffer layer 302; a lower semiconductor DBR 303; a lower spacer layer 304; an active layer 305; an upper spacer layer 306; an upper semiconductor DBR 307; a contact layer 309; a p-side electrode 313; and a n-side electrode 314. The substrate 301 is a n-GaAs crystal substrate.

The buffer layer 302 is stacked on the +Z side of the substrate 301 and comprises n-GaAs. The lower semiconductor DBR 303 is stacked on the +Z side of the buffer layer 302 and includes 55.5 pairs of a low-refractive index layer of n-AIAs and a high-refractive index layer of n-Al_{0.5}Ga_{0.5}As. Between the refractive index layers, in order to reduce electric resistance, a graded composition layer having a thickness of 20 nm is provided in which the composition is gradually changed from one composition to another. Each of the refractive index layers has an optical thickness of λ/4 including one half of the adjacent graded composition layers, where λ is the oscillation wavelength.

The lower spacer layer 304 is stacked on the +Z side of the lower semiconductor DBR 303 and comprises (Al_{0.5}Ga_{0.5})_{0.5}In_{0.5}P. The active layer 305 is stacked on the +Z side of the lower spacer layer 304 and has a triple quantum well structure of GaInP/AlGaInP. The upper spacer layer 306 is stacked on the +Z side of the active layer 305 and comprises (Al_{0.5}Ga_{0.5})_{0.5}In_{0.5}P. A portion including the lower spacer layer 304, the active layer 305, and the upper spacer layer 306 is referred to as a cavity structure. The thickness of the cavity structure is set to correspond to the optical thickness of a single wavelength. The active layer 305 is disposed at the center of the cavity structure corresponding to an anti-node of the standing wave distribution of an electric field so that a high probability of induced emission can be obtained.

The upper semiconductor DBR 307 is stacked on the +Z side of the upper spacer layer 306 and includes 35 pairs of a low-refractive index layer of p-Al_{0.95}Ga_{0.05}As and a high-refractive index layer of p-Al_{0.5}Ga_{0.5}As. Between the refractive index layers, in order to reduce electric resistance, a graded composition layer is provided in which the composition is gradually changed from one composition to another. The refractive index layers are set to have an optical thickness corresponding to λ/4 including one half of the adjacent graded composition layers. In one of the low-refractive index layers of the upper semiconductor DBR 307, a selectively oxidized layer 308 of p-AlAs having a thickness of 33 nm is inserted.

The selectively oxidized layer 308 is inserted at a position corresponding to the third node from the active layer 305 in the standing wave distribution of an electric field. In this way, the portion that generates heat due to the increase in resistance caused by current confinement can be located away from the active layer, while maintaining a practical threshold current. Further, thermal resistance can be reduced, so that the localized heating of the element central portion can be reduced. Furthermore, the influence of strain on the active layer due to the selective oxidation of the selectively oxidized layer 308 can be reduced, so that the element lifespan can be increased. The contact layer 309 is stacked on the +Z side of the upper semiconductor DBR 307 and comprises p-GaAs.

In some of the layers of the upper semiconductor DBR 307 closer to the cavity structure, the doping concentration of the p-type dopant is adjusted to be lower than in the other regions. The dopant may include C from carbon tetrabromide (CBr₄) as a raw material. Specifically, four of the pairs in the upper semiconductor DBR 307 in an area adjacent the upper spacer layer 306 form a low-doping concentration area having a lower doping concentration than the doping concentration of the remaining 31 pairs. Specifically, the doping concentration may be in a range between 5×10¹⁷ and 1×10¹⁸ atoms/cm³ for the low-doping concentration area, and between 1.5×10¹⁸ and 5×10¹⁸ atoms/cm³ for the remaining 31 pairs.

In some of the layers of the lower semiconductor DBR 303 closer to the cavity structure, the doping concentration of the n-type dopant is adjusted to be lower than in the other regions. The n-dopant may include Se from hydrogen selenide (H₂Se) as a raw material. Specifically, four of the pairs in the lower semiconductor DBR 303 in an area adjacent the lower spacer layer 304 form a low-doping concentration area having a lower doping concentration than the doping concentration of the remaining 51.5 pairs. Specifically, the doping concentration may be in a range between 5×10¹⁷ and 1×10¹⁸ atoms/cm³ for the low-doping concentration area and between 1.5×10¹⁸ and 3×10¹⁸ atoms/cm³ for the remaining 51.5 pairs. Thus, in each of the semiconductor DBRs, the portion adjacent the cavity structure has a lower doping concentration than the concentration of the other regions.

The standing wave intensity of light in the semiconductor DBR is reduced in half about four pairs away from the active layer. Thus, by setting the doping concentration of the large-intensity-distribution region at a lower value, free carrier absorption can be effectively reduced. The decrease in absorption loss enables a decrease in oscillation threshold current, so that slope efficiency can be improved and the element drive current can be reduced. Thus, the required power and heat generation can be reduced.

The lower spacer layer 304 is doped with an n-type dopant, which may include Se from hydrogen selenide (H₂Se) as a raw material. Specifically, the doping concentration may be in a range between 5×10¹⁷ and 1×10¹⁸ atoms/cm³. The upper spacer layer 306 is almost entirely un-doped, except for a portion having a thickness on the order of several dozen nm adjacent the upper semiconductor DBR 307, where the n-type dopant diffused from the upper semiconductor DBR 307 is contained.

In the surface emitting laser element 100E, the element resistance is lowered as in the surface emitting laser element 100A without lowering the emission characteristics. The surface emitting laser element 100E may be manufactured by a process similar to the process for the surface emitting laser element 100A. In FIG. 22, numeral 308a designates an Al oxidized layer produced by the selective oxidation of Al in the selectively oxidized layer 308, and numeral 308b designates a current passage area. Numeral 311 designates a protection layer of SiN. Thus, by using an AlGaInP active layer, element resistance can be reduced without lowering emission characteristics even in the surface emitting laser element with the oscillation wavelength of the 660 nm band, as in the foregoing embodiment. Thus, the active layer may be modified according to the particular design.

### Example 5

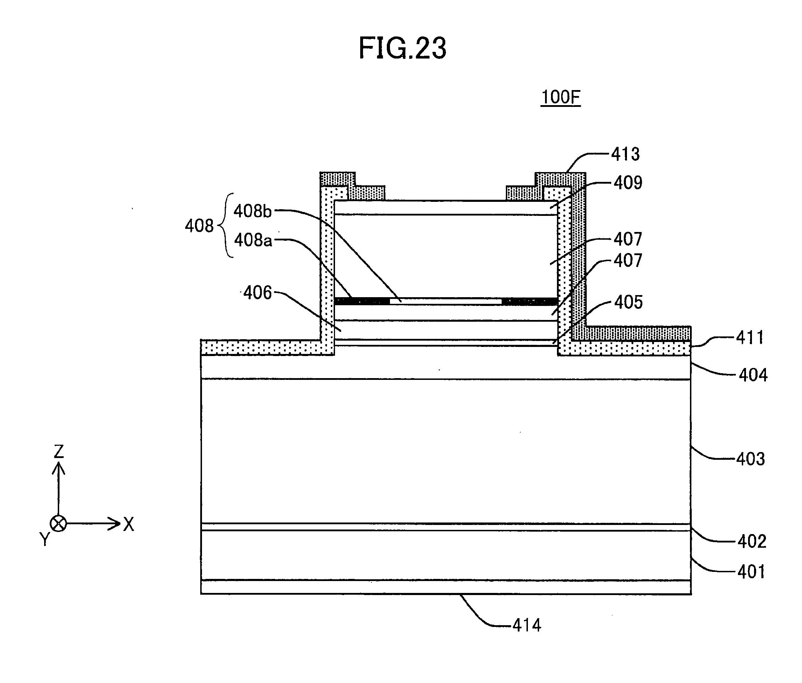

FIG. 23 illustrates a surface emitting laser element 100F with the oscillation wavelength of the 660 nm band. The surface emitting laser element 100F includes a substrate 401; a buffer layer 402; a lower semiconductor DBR 403; a lower spacer layer 404; an active layer 405; an upper spacer layer 406; an upper semiconductor DBR 407; a contact layer 409; a p-side electrode 413; and a n-side electrode 414.

The substrate 401 is a n-GaAs single-crystal substrate. The buffer layer 402 is stacked on the +Z side of the substrate 401 and comprises n-GaAs. The lower semiconductor DBR 403 is stacked on the +Z side of the buffer layer 402 and includes 55.5 pairs of a low-refractive index layer of n-AlAs and a high-refractive index layer of n-Al_{0.5}Ga_{0.5}As. Between the refractive index layers, in order to reduce electric resistance, there is provided a graded composition layer having a thickness of 20 nm in which the composition is gradually changed from one composition to another. Each refractive index layer has an optical thickness of λ/4 including one half of the adjacent graded composition layers, where λ is the oscillation wavelength.

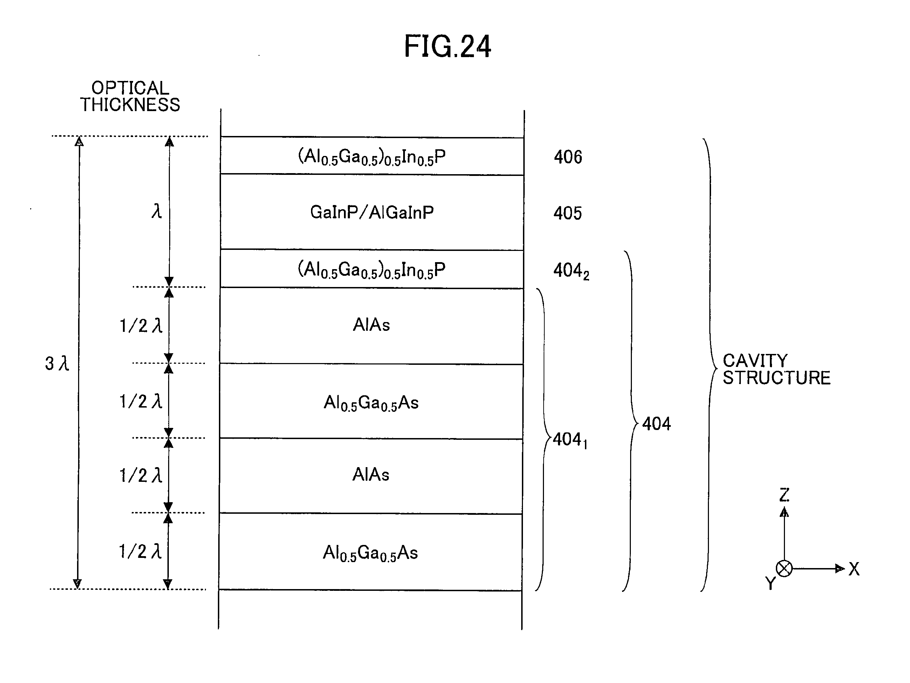

The lower spacer layer 404 includes a first lower spacer layer 404₁ and a second lower spacer layer 404₂, as illustrated in FIG. 24. The first lower spacer layer 404₁ is stacked on the +Z side of the lower semiconductor DBR 403 and includes two pairs of a first layer of Al_{0.5}Ga_{0.5}As and a second layer of n-AIAs. The first layer and the second layer have an optical thickness of 1/2λ, so that the first lower spacer layer 404₁ has an optical thickness of 2λ. The second lower spacer layer 404₂ is stacked on the +Z side of the first lower spacer layer 404₁ and comprises (Al_{0.5}Ga_{0.5})_{0.5}In_{0.5}P. The active layer 405 is stacked on the +Z side of the second lower spacer layer 404₂ and has a triple quantum well structure of GaInP/AlGaInP. The upper spacer layer 406 is stacked on the +Z side of the active layer 405 and comprises (Al_{0.5}Ga_{0.5})_{0.5}In_{0.5}P.

The portion including the lower spacer layer 404, the active layer 405, and the upper spacer layer 406 is referred to as a cavity structure whose optical thickness is set to correspond to three wavelengths. The upper semiconductor DBR 407 is stacked on the +Z side of the upper spacer layer 406 and includes 35 pairs of a low-refractive index layer of pAl_{0.95}Ga_{0.05}As and a high-refractive index layer of p-Al_{0.5}Ga_{0.5}As. Between the refractive index layers, in order to reduce electric resistance, there is provided a graded composition layer in which the composition is gradually changed from one composition to another. Each of the refractive index layers has an optical thickness of λ/4 including one half of the adjacent graded composition layers.

In one of the low-refractive index layers in the upper semiconductor DBR 407, a selectively oxidized layer 408 of p-AlAs having a thickness of 33 nm is inserted. The selectively oxidized layer 408 is inserted at a position corresponding to the third node from the active layer 405 in the standing wave distribution of an electric field. In this way, the portion that generates heat due to the increase in resistance caused by current confinement can be located away from the active layer while maintaining a practical threshold current. Further, thermal resistance can be reduced, so that the localized heating of the element central portion can be reduced. In addition, the influence of strain on the active layer due to the selective oxidation of the selectively oxidized layer 408 can be reduced, so that the element lifespan can be increased. The contact layer 409 is stacked on the +Z side of the upper semiconductor DBR 407 and comprises p-GaAs.

In some of the layers in the upper semiconductor DBR 407 closer to the cavity structure, the doping concentration of the p-type dopant is adjusted to be lower than in the other regions. The p-type dopant may include C from carbon tetrabromide (CBr₄) as a raw material. Specifically, four of the pairs in the upper semiconductor DBR 407 in a region adjacent the upper spacer layer 406 form a low-doping concentration area having a lower doping concentration than in the remaining 31 pairs. Specifically, the doping concentration may be in a range between 5×10¹⁷ and 1×10¹⁸ atoms/cm³ for the low-doping concentration area and between 1.5×10¹⁸ and 5×10¹⁸ atoms/cm³ for the remaining 31 pairs.

In some of the layers in the lower semiconductor DBR 403 closer to the cavity structure, the doping concentration of the n-type dopant is adjusted to be lower than in the other regions. The n-type dopant may include Se from hydrogen selenide (H₂Se) as a raw material. Specifically, four of the pairs in the lower semiconductor DBR 403 in a region adjacent the lower spacer layer 404 form a low-doping concentration area having a lower doping concentration than in the remaining 51.5 pairs. More specifically, the doping concentration may be in a range between 5×10¹⁷ and 1×10¹⁸ atoms/cm³ for the low-doping concentration area and between 1.5×10¹⁸ and 3×10¹⁸ atoms/cm³ for the remaining 51.5 pairs. Thus, the portion of each of the semiconductor DBRs adjacent the cavity structure has a lower doping concentration.

The standing wave intensity of light in the semiconductor DBR is reduced in half about four pairs away from the active layer. Thus, by setting the doping concentration of the large-intensity-distribution region to a low value, free carrier absorption can be effectively reduced. The decrease in absorption loss enables a decrease in oscillation threshold current, so that slope efficiency can be improved. As a result, the element drive current and the required power can be reduced, thereby reducing heat generation.

In the surface emitting laser element 100F, element resistance can be lowered without lowering emission characteristics, as in the surface emitting laser element 100A. The surface emitting laser element 100F can be manufactured by a process similar to the process for the surface emitting laser element 100A.

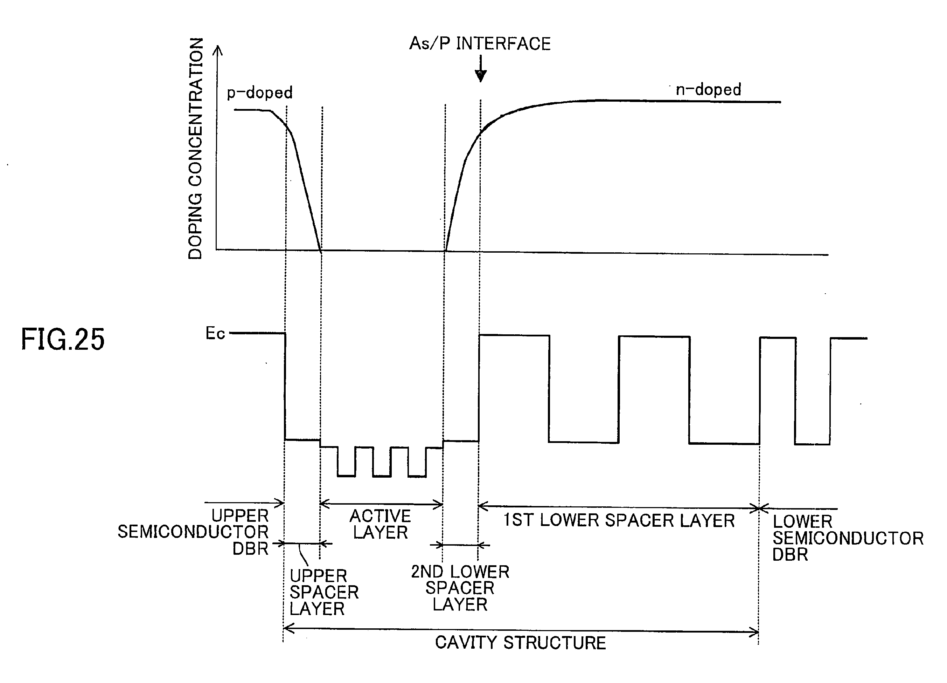

In the surface emitting laser element 100F, the interface between the AlGaInPAs material and the AlGaAs material is near the active region. In this case, the element resistance can be reduced without lowering emission characteristics when the As/P interface (see FIG. 25) is positioned closer to the active layer with respect to the boundary of the cavity structure and the semiconductor DBR, and when the n-doped region is extended beyond the As/P interface, as in the foregoing embodiment. Thus, the As/P interface on the n-side may be shifted toward the active layer with respect to the boundary of the cavity structure and the lower semiconductor DBR according to the particular design.

In FIG. 23, numeral 408a designates an Al oxidized layer produced by the selective oxidation of Al in the selectively oxidized layer 408. Numeral 408b designates a current passage area. Numeral 411 designates a protection layer of SiN.

The surface emitting laser elements according to the various embodiments of the present invention may be applied for purposes other than an image forming apparatus. The oscillation wavelength may be in various bands depending on the purpose, such as the 660 nm band, the 780 nm band, the 850 nm band, the 980 nm band, the 1.3 µm band, or the 1.5 µm band. In these cases, the semiconductor material for the active layer may include a mixed crystal semiconductor material suitable for the oscillation wavelength. For example, an InGaAs mixed crystal semiconductor material may be used for the 980 nm band, or a GaInNAs(Sb) mixed crystal semiconductor material may be used for the 1.3 µm band or the 1.5 µm band.

By selecting the material and structure of each reflector depending on the oscillation wavelength, an emitting portion suitable for a desired oscillation wavelength can be formed. Preferably, the low-refractive index layer and the high-refractive index layer are transparent with respect to the oscillation wavelength and their combination is selected such that the refractive index difference between them can be maximized.

While the optical scanning apparatus 1010 is applied to a printer in the foregoing embodiments, the optical scanning apparatus 1010 may be applied for an image forming apparatus other than a printer, such as a copy machine, facsimile machine, or a multifunction peripheral. The laser printer 1000 is merely an example of an image forming apparatus. The image forming apparatus may be of a type in which a recording medium, such as a sheet of paper, is directly irradiated with laser light. For example, an embodiment of the present invention may be applied for CTP (Computer to Plate) imaging technology. Specifically, the optical scanning apparatus 1010 may be configured to form an image directly onto a printing plate as an image carrier by laser abrasion.

The recording medium may include a rewritable paper comprising a support, which may be a sheet of paper or film of a resin material, onto which a recording layer material is applied. The recording layer material is configured to develop or lose color depending on the thermal energy of the irradiating laser light, thus enabling the control of appearance or disappearance of a displayed color.

Such rewritable technology includes a transparent/opaque type rewritable marking method and a coloring/discoloring type rewritable marking method using leuco dye. The present invention may be applied to both. The transparent/opaque type employs a polymer thin film in which fine particles of fatty acid are dispersed. When the polymer thin film is heated to 110°C or above, the fatty acid melts and the resin expands. Upon cooling, the fatty acid is placed in a supercooled state such that the fatty acid remains in liquid form while the expanded resin is solidified. Thereafter, the fatty acid is solidified and contracted into polycrystalline fine particles, leaving gaps between the resin and the fine particles. The gaps scatter light, appearing white. When the polymer thin film is heated to an erasing temperature range between 80°C and 110°C, some of the fatty acid melts such that the resin is thermally expanded, thus filling the gaps. Upon cooling with the gaps gone, the film appears transparent; i.e., an image can be erased.

On the other hand, the rewritable marking method using leuco dye is based on a reversible coloring reaction between a colorless leuco dye and a developer having a long-chain alkyl group. When heated by laser light, the leuco dye and the developer react to each other to produce a color. Upon rapid cooling, the colored state is preserved. Upon slow cooling after heating, a phase separation occurs due to autoagglutination of the developer, by which the leuco dye and the developer are separated from each other, thus losing the color.

The recording medium may also include a so-called color rewritable paper that comprises a support, such as a sheet of paper or a resin film, on which photochromic compounds are provided. The photochromic compounds may include a photochromic compound that appears cyan (C) upon irradiation with ultraviolet light where the color disappears upon irradiation with the visible light of red (R); a photochromic compound that appears magenta (M) upon irradiation with ultraviolet light where the color M disappears upon irradiation with the visible light of green (G); and a photochromic compound that appears yellow (Y) upon irradiation with ultraviolet light where the color disappears upon irradiation with the visible light of blue (B).

Such a color rewritable paper may be caused to appear black upon irradiation with ultraviolet light, develop full colors by controlling the color density of the three kinds of material for developing Y, M, and C by adjusting the duration of time or intensity of irradiation of the R, G, or B light, and then appear white by irradiating strong R, G, and B lights for a required period of time.

The image carrier may include a film of silver halide photosensitive material. In this case, a latent image formed on the silver halide photosensitive film by optical scan may be developed into a visible image by a process similar to the conventional silver halide photography process. The developed image may then be transferred onto a printing paper in a process similar to the conventional printing process according to silver halide photography. Such an image forming apparatus may be used as an optical print making apparatus or an optical image-drawing apparatus configured to draw a CT scan image or the like.

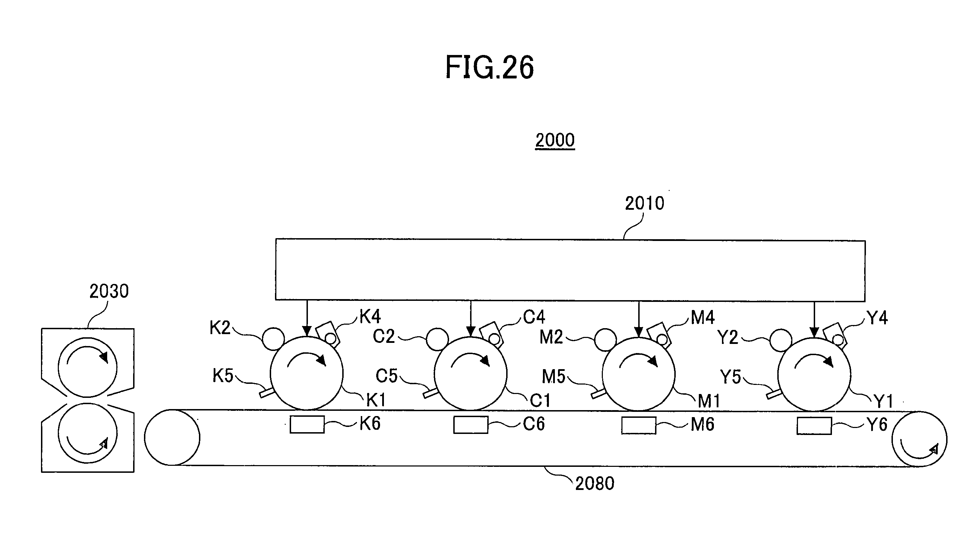

FIG. 26 illustrates a color printer 2000 having a plurality of photosensitive drums according to an embodiment of the present invention. The color printer 2000 is of a tandem-type configured to form a full color image by superposing four colors of black, cyan, magenta, and yellow on a recording medium such as a recording paper. Thus, the color printer 2000 includes photosensitive drums K1, a charging unit K2, a developing unit K4, a cleaning unit K5, and a transfer unit K6 for black (K); a photosensitive drum C1, a charging unit C2, a developing unit C4, a cleaning unit C5, and a transfer unit C6 for cyan (C); a photosensitive drum M1, a charging unit M2, a developing unit M4, a cleaning unit M5, and a transfer unit M6 for magenta (M); and a photosensitive drum Y1, a charging unit Y2, a developing unit Y4, a cleaning unit Y5, and a transfer unit Y6 for yellow (Y). The color printer 2000 also includes an optical scanning apparatus 2010, a transport belt 2080, and a fusing unit 2030. Any of the photosensitive drums for the various colors may be referred to as "the photosensitive drum". Similarly, any of the charging units, the developing units, the cleaning units, and the transfer units for the various colors may be referred to as "the charging unit", "the developing unit", "the cleaning unit", and "the transfer unit", respectively.

The photosensitive drum is rotated in a direction indicated by an arrow shown on the photosensitive drum in FIG. 26. The charging unit, the developing unit, the transfer unit, and the cleaning unit are disposed around the photosensitive drum. The charging unit is configured to uniformly charge a surface of the photosensitive drum. The charged surface of the photosensitive drum is irradiated with light emitted from the optical scanning apparatus 2010 in order to form a latent image on the photosensitive drum surface. The developing unit attaches the toner of the corresponding color to the photosensitive drum surface, thus forming a toner image of the corresponding color. The toner images of the various colors are then transferred by the transfer units to be superposed onto a recording sheet transported by the transport belt 2080. The superposed image is then fused onto the recording sheet by the fusing unit 2030.

The optical scanning apparatus 2010 may include one of the surface emitting laser elements 100A, 100B, 100C, 100D, 100E, and 100F, or the surface emitting laser array 100M as a light source for each of the colors. Thus, the optical scanning apparatus 2010 can provide the same advantageous effects as those by the optical scanning apparatus 1010. The color printer 2000 having the optical scanning apparatus 2010 can provide the same advantageous effects as those of the laser printer 1000.

In the color printer 2000, a color registration error may be caused by a manufacturing or positional error of the various components. Such a color registration error can be reduced by selecting the light-emitting portions of the surface emitting laser array 100M of the optical scanning apparatus 2010 that are to be turned on.

Thus, in the surface emitting laser element according to an embodiment of the present invention, the element resistance is reduced without lowering emission characteristics. The surface emitting laser array according to an embodiment of the present invention can be suitably used for reducing element resistance without degrading emission characteristics. The optical scanning apparatus according to an embodiment of the present invention can be suitably used for a highly accurate optical scanning operation. The image forming apparatus according to an embodiment of the present invention can be suitably used for forming a high-quality image.

Although this invention has been described in detail with reference to certain embodiments, variations and modifications exist within the scope and spirit of the invention as described and defined in the following claims.

## Claims

1. A surface emitting laser element comprising:
a p-side spacer layer;
an n-side spacer layer; and
an active layer disposed between the p-side spacer layer and the n-side spacer layer,
wherein the p-side spacer layer includes an undoped region adjacent to the active layer in which no p-type dopant is contained, and
the n-side spacer layer is doped with an n-type dopant.

2. The surface emitting laser element according to claim 1, wherein the p-side spacer layer, the active layer, and the n-side spacer layer are disposed between an n-type semiconductor multilayer reflector and a p-type semiconductor multilayer reflector,
wherein the n-side spacer layer includes (AlₓGa₍₁₋ₓ₎)_{y}In_{(1-y)}P containing an n-type dopant, where 0 ≤ x ≤ 1 and 0 ≤ y ≤ 1, and
a layer of the n-type semiconductor multilayer reflector that is adjacent to the n-side spacer layer includes Al_{z}Ga_{(1-z)}As, where 0 ≤ z ≤ 1.

3. The surface emitting laser element according to claim 2, wherein a portion of the n-side spacer layer that is adjacent to the n-type semiconductor multilayer reflector is doped with the n-type dopant in a doping amount greater than the doping amount of the n-type dopant in the n-type semiconductor multilayer reflector.

4. The surface emitting laser element according to claim 2 or 3, wherein the active layer has a quantum-well structure having a quantum-well layer of Ga_{α}In_{(1-α)}As_{β}P_{(1-β),} where 0 ≤ α ≤ 1 and 0 ≤ β ≤ 1.

5. The surface emitting laser element according to any one of claims 1 through 4, wherein a portion of the active layer that is adjacent to the n-side spacer layer is doped with the n-type dopant.

6. The surface emitting laser element according to claim 5, wherein the doping amount of the n-type dopant is equal to or less than 5×10¹⁷ atoms/cm³.

7. A surface emitting laser array comprising plural of the surface emitting laser elements according to any one of claims 1 through 6.

8. An optical scanning apparatus comprising:
a light source including the surface emitting laser element according to any one of claims 1 through 6;
a deflector configured to deflect light emitted from the light source; and
a scanning optical system configured to focus the light deflected by the deflector on a scanned surface.

9. An optical scanning apparatus comprising:
a light source including the surface emitting laser array according to claim 7;
a deflector configured to deflect light emitted from the light source; and
a scanning optical system configured to focus the light deflected by the deflector on a scanned surface.

10. An image forming apparatus comprising:
an image carrier; and
the optical scanning apparatus according to claim 8 or 9 configured to scan the image carrier with the light modulated in accordance with image information.

11. The image forming apparatus according to claim 10. wherein the image information includes multiple-color image information.
